# EUROPEAN PATENT APPLICATION

(11) **EP 4 625 455 A1**
(43) Date of publication of application: **01.10.2025**
(21) Application number: 25166046.0
(22) Date of filing: 25.03.2025
(51) Int. Cl.: H01F 27/28, H01F 27/29, H01F 27/30, H01F 27/32, H05K 1/18

(54) **BLOCK COIL**

(30) Priority: 29.03.2024 US 202463571525 P
(71) Applicant: Murata Manufacturing Co., Ltd., Nagaokakyo-shi, Kyoto 617-8555 (JP)
(72) Inventor: FRANCIS, Lee, Kyoto, 617-8555 (JP); WARNES, Frank, Kyoto, 617-8555 (JP); TANGE, Takayuki, Kyoto, 617-8555 (JP)
(74) Representative: Frick, Robert

(57) **Abstract**

An electronic module including a substrate (20) or a lead frame including a conductive pattern (23); a magnetic core (30) located on or above the substrate or the lead frame; first and second block coils (10) connected by a bridge (14) to define a single unitary component, each of the first and the second block coils including a resin body that is located on or above the substrate or the lead frame and that extends over the magnetic core and a first terminal (11) that is on or embedded in the resin body and that is connected to the conductive pattern; an electronic component located on the substrate or the lead frame; and an insulating material (40) covering the substrate or the lead frame, the magnetic core, and the block coil.

## Description

### CROSS REFERENCE TO RELATED APPLICATIONS

This application claims the benefit of U.S. Patent Application No. 63/571,525 filed on March 29, 2024. The entire contents of this application are hereby incorporated by reference.

### BACKGROUND OF THE INVENTION

### 1. Field of the Invention

The present invention relates to block coils. More specifically, the present invention relates to block coils that can be attached to a substrate or a lead frame and that can be used in a magnetic component or an electronic module.

### 2. Description of the Related Art

It is known to use windings that include terminals that extend over a magnetic core. Because no structure supports the terminals, there is a risk that the terminals will short circuit or fall sideways.

### SUMMARY OF THE INVENTION

To overcome the problems described above, example embodiments of the present invention provide block coils that include a resin body and terminals on or in the resin body such that the risks of the block coil causing a short circuit and the terminals falling are eliminated or greatly reduced. The magnetic core can include one or more gaps. The one or more gaps increase the power handling capability of the magnetic core by delaying core saturation.

According to an example embodiment of the present invention, an electronic module includes a substrate or a lead frame including a primary conductive pattern and a secondary conductive pattern; a magnetic core located on or above the substrate or the lead frame; a block coil including a resin body that is located on or above the substrate or the lead frame and that includes first, second, third, and fourth legs that extend over the magnetic core, a first terminal that is on or embedded in the first and the second legs such that the first terminal extends over the magnetic core and that is connected to the primary conductive pattern, and a second terminal that is on or embedded in the third and the fourth legs such that the second terminal extends over the second section of the magnetic core and that is connected to the secondary conductive pattern; and an electronic component located on the substrate or the lead frame.

The block coil can include additional first terminals and additional second terminals; the first terminal and the additional first terminals can define a first terminal group; and the second terminal and the additional second terminals can define a second terminal group. Each terminal in the first terminal group can be connected to a corresponding primary conductive pattern; and each terminal in the second terminal group can be connected to a corresponding secondary conductive pattern. The first terminal group can be located next to and spaced away from the second terminal group.

The substrate or the lead frame can include first and second layers. The primary conductive pattern can be in the first layer; the secondary conductive pattern can be in the second layer; and from a side view of the substrate, a portion of the primary conductive pattern and a portion of the secondary conductive pattern can overlap vertically. The electronic module can further include an additional primary conductive pattern in a third layer of the substrate and an additional secondary conductive pattern in a fourth layer of the substrate, wherein from the side view of the substrate, a portion of the additional primary conductive pattern and a portion of the additional secondary conductive pattern can overlap vertically.

The electronic module can further include an insulating material covering the substrate or the lead frame, the magnetic core, and the block coil. The electronic component can include an integrated circuit (IC) and/or a capacitor. The block coil can include an inner tapered portion to which the magnetic core is connected.

According to an example embodiment of the present invention, an electronic module includes a substrate or a lead frame including a conductive pattern; a magnetic core located on or above the substrate or the lead frame; first and second block coils connected by a bridge to define a single unitary component, each of the first and the second block coils including a resin body that is located on or above the substrate or the lead frame and that extends over the magnetic core and including a first terminal that is on or embedded in the resin body and that is connected to the conductive pattern; an electronic component located on the substrate or the lead frame; and an insulating material covering the substrate or the lead frame, the magnetic core, and the block coil.

The conductive pattern can be a primary conductive pattern, and the first terminal of the first block coil can be connected only to the primary conductive pattern. The conductive pattern can be a secondary conductive pattern, and the first terminal of the second block coil can be connected only to the secondary conductive pattern. The block coil can include an inner tapered portion to which the magnetic core is connected.

The first block coil can include a first terminal group and a second terminal group, and the first terminal of the first block coil can be included in the first terminal group. Each terminal in the first terminal group can be connected to a corresponding primary conductive pattern, and each terminal in the second terminal group can be connected to a corresponding secondary conductive pattern. Each terminal in the first terminal group and each terminal in the second terminal group can be connected to a corresponding primary conductive pattern. Each terminal in the first terminal group and each terminal in the second terminal group can be connected to a corresponding secondary conductive pattern. The first group can be located next to and spaced away from the second group.

The substrate or the lead frame can include first and second layers. The electronic module can further include a primary conductive pattern in the first layer and a secondary conductive pattern in the second layer, wherein from a side view of the substrate, a portion of the primary conductive pattern and a portion of the secondary conductive pattern can overlap vertically. The electronic module can further include an additional primary conductive pattern in a third layer of the substrate and an additional secondary conductive pattern in a fourth layer of the substrate, wherein from the side view of the substrate, a portion of the additional primary conductive pattern and a portion of the additional secondary conductive pattern can overlap vertically.

The electronic component can include an integrated circuit (IC) and/or a capacitor.

According to an example embodiment of the present invention, a magnetic component includes a substrate or a lead frame including a primary conductive pattern and a secondary conductive pattern; a magnetic core located on or above the substrate or the lead frame; a block coil including a resin body that is located on or above the substrate or the lead frame and that includes first, second, third, and fourth legs that extend over the magnetic core, a first terminal that is on or embedded in the first and the second legs such that the first terminal extends over the magnetic core and that is connected to the primary conductive pattern, and a second terminal on or embedded in the third and the fourth legs such that the second terminal extends over the second section of the magnetic core and that is connected to the secondary conductive pattern; and an insulating material covering the substrate or the lead frame, the magnetic core, and the block coil.

The magnetic core can be located on the substrate or the lead frame. The magnetic core can be located above the substrate or the lead frame and can be attached to an inner, upper surface of the block coil. The magnetic component can further include a coating covering the magnetic core.

The block coil can include additional first terminals and additional second terminals; the first terminal and the additional first terminals can define a first terminal group; and the second terminal and the additional second terminals can define a second terminal group. Each terminal in the first terminal group can be connected to a corresponding primary conductive pattern, and each terminal in the second terminal group can be connected to a corresponding secondary conductive pattern. The first terminal group can be located next to and spaced away from the second terminal group.

The substrate or the lead frame can include first and second layers; the primary conductive pattern can be in the first layer; the secondary conductive pattern can be in the second layer; and from a side view of the substrate or lead frame, a portion of the primary conductive pattern and a portion of the secondary conductive pattern can overlap vertically. The magnetic component can further include an additional primary conductive pattern in a third layer of the substrate or the lead frame and an additional secondary conductive pattern in a fourth layer of the substrate or the lead frame, wherein from the side view of the substrate or the lead frame, a portion of the additional primary conductive pattern and a portion of the additional secondary conductive pattern can overlap vertically.

The block coil can include an inner tapered portion to which the magnetic core is connected.

According to an example embodiment of the present invention, a magnetic component including a substrate or a lead frame including a first layer, and a conductive pattern; a magnetic core located on or above the substrate or the lead frame; first and second block coils connected by a bridge to define a single unitary component, each of the first and the second block coils including a resin body that is located on or above the substrate or the lead frame and that extends over the magnetic core and a first terminal that is on or embedded in the resin body and that is connected to the conductive pattern; and an insulating material covering the substrate or the lead frame, the magnetic core, and the block coil.

The magnetic core can be located on the substrate or the lead frame. The magnetic core can be located above the substrate or the lead frame and can be attached to an inner, upper surface of the first block coil and/or the second block coil. The magnetic component can further include a coating covering the magnetic core.

The magnetic component can further include a primary conductive pattern and a secondary conductive pattern, wherein the first terminal of the first block coil can be connected only to the primary conductive pattern and wherein the first terminal of the second block coil can be connected only to the secondary conductive pattern. The block coil can include an inner tapered portion to which the magnetic core is connected. The first block coil can include a first terminal group and a second terminal group; the first terminal of the first block coil can be included in the first terminal group; each terminal in the first terminal group can be connected to a corresponding primary conductive pattern; and each terminal in the second terminal group can be connected to a corresponding secondary conductive pattern. The first group can be located next to and spaced away from the second group. The magnetic component can further include a primary conductive pattern in the first layer and a secondary conductive pattern in a second layer of the substrate or the lead frame, wherein from a side view of the substrate or the lead frame, a portion of the primary conductive pattern and a portion of the secondary conductive pattern can overlap vertically. The magnetic component can further include an additional primary conductive pattern in a third layer of the substrate or the lead frame and an additional secondary conductive pattern in a fourth layer of the substrate or the lead frame, wherein from the side view of the substrate, a portion of the additional primary conductive pattern and a portion of the additional secondary conductive pattern can overlap vertically.

According to an example embodiment of the present invention, an electronic module includes a substrate or a lead frame including primary conductive patterns and secondary conductive patterns; a magnetic core located on or above the substrate or the lead frame; a block coil including a resin body that is located on or above the substrate or the lead frame and that includes first, second, third, and fourth legs that extend over the magnetic core, first terminals that define a first terminal group and that are on or embedded in the first and the second legs such that the first terminal extends over the magnetic core, and second terminals that define a second terminal group and that on or are embedded in the third and the fourth legs such that the second terminal extends over the second section of the magnetic core; an IC located on the substrate or the lead frame; and a capacitor located on the substrate or the lead frame. Two first terminals of the first terminal group are connected to corresponding primary conductive patterns; two second terminals of the second terminal group are connected corresponding secondary conductive patterns; and a first primary conductive pattern is closer to a second primary conductive pattern than any of the secondary conductive patterns.

Each first terminal in the first terminal group can be connected to a corresponding primary conductive pattern, and each second terminal in the second terminal group can be connected to a corresponding secondary conductive pattern. The first terminal group can be located next to and spaced away from the second terminal group.

The substrate or the lead frame can include first and second layers. The primary conductive patterns can be in the first layer; the secondary conductive patterns can be in the second layer; and from a side view of the substrate, portions of the primary conductive patterns can overlap vertically corresponding portions of the secondary conductive patterns. The electronic module can further include additional primary conductive patterns in a third layer of the substrate and additional secondary conductive patterns in a fourth layer of the substrate, wherein from the side view of the substrate, portions of the additional primary conductive patterns can overlap vertically corresponding portions of the additional secondary conductive pattern.

The electronic module can further include an insulating material covering the substrate or the lead frame, the magnetic core, and the block coil. The electronic module can include the substrate, and the substrate can include a via hole. The magnetic core can be located on or above a first surface of the substrate or the lead frame, and the capacitor can be located on a second surface of the substrate or the lead frame opposite to the first surface. The electronic module can further include a coating covering the magnetic core. The block coil can include an inner tapered portion to which the magnetic core is connected.

According to an example embodiment of the present invention, an electronic module includes a substrate or a lead frame including primary conductive patterns and secondary conductive patterns; a magnetic core located on or above the substrate or the lead frame; first and second block coils connected by a bridge to define a single unitary component, each of the first and the second block coils includes a resin body that is located on or above the substrate or the lead frame and that extends over the magnetic core, first terminals that define a first terminal group and that are on or embedded in the resin body, and second terminals that define a second terminal group and that are on or embedded in the resin body; an IC located on the substrate or the lead frame; and a capacitor located on the substrate or the lead frame. Two first terminals of the first terminal group are connected to corresponding primary conductive patterns; two second terminals of the second terminal group are connected corresponding secondary conductive patterns; and a first primary conductive pattern is closer to a second primary conductive pattern than any of the secondary conductive patterns.

Each first terminal in the first terminal group can be connected to a corresponding primary conductive pattern, and each second terminal in the second terminal group can be connected to a corresponding secondary conductive pattern. The first terminal group can be located next to and can be spaced away from the second terminal group.

The substrate or the lead frame can include first and second layers. The primary conductive patterns can be in the first layer; the secondary conductive patterns can be in the second layer; and from a side view of the substrate, portions of the primary conductive patterns can overlap vertically corresponding portions of the secondary conductive patterns. The electronic module can further include additional primary conductive patterns in a third layer of the substrate and additional secondary conductive patterns in a fourth layer of the substrate, wherein from the side view of the substrate, portions of the additional primary conductive patterns can overlap vertically corresponding portions of the additional secondary conductive pattern.

The electronic module can further include an insulating material covering the substrate or the lead frame, the magnetic core, and the block coil. The electronic module can include the substrate, and the substrate can include a via hole. The magnetic core can be located on or above a first surface of the substrate or the lead frame, and the capacitor can be located on a second surface of the substrate or the lead frame opposite to the first surface. The electronic module can further include a coating covering the magnetic core. The block coil can include an inner tapered portion to which the magnetic core is connected.

The above and other features, elements, characteristics, steps, and advantages of the present invention will become more apparent from the following detailed description of example embodiments of the present invention with reference to the attached drawings.

### BRIEF DESCRIPTION OF THE DRAWINGS

Fig. 1 is a top perspective view of block coils mounted to a substrate of a magnetic component.
Fig. 2 is a top view of the block coils mounted to a PCB of the magnetic component of Fig. 1.
Fig. 3 is a top perspective view of block coils mounted to a PCB of the magnetic component of Fig. 1 in an electronic module.
Fig. 4 is a top perspective view of the electronic module of Fig. 3 with insulating material covering the block coils.
Fig. 5 is a top view of the electronic module of Fig. 3.
Fig. 6 is top perspective view of the block coil of Fig. 1.
Fig. 7 is bottom perspective view of the block coil of Fig. 1.
Fig. 8 is a top perspective view of block coils with terminals with different widths.
Fig. 9 shows top views of different layers of the PCB that can be used with the electronic module of Fig. 3.
Fig. 10 is a partial sectional view of the electronic module of Fig. 4 with insulating material covering the block coils.
Figs. 11-15 are perspective views showing a method of manufacturing the electronic module of Fig. 3.
Fig. 16 is a sectional view of block coil mounted to a single-layer substrate of an electronic component.
Fig. 17 is a top view of the top layer of the substrate of Fig. 16.
Fig. 18 is a sectional view of a magnetic component showing various distances.
Fig. 19 is a top perspective view of block coils mounted to lead frame of a magnetic component.
Fig. 20 is a side sectional view of the block coils mounted to the lead frame of the magnetic component of Fig. 19.
Fig. 21 is a bottom perspective view of the block coils mounted to the lead frame of the magnetic component of Fig. 19.
Fig. 22 is a top perspective view of a partially assembled magnetic component of Fig. 20.
Fig. 23 is a top perspective view of the magnetic component of Fig. 20 with insulating material covering the block coils.
Fig. 24 shows an E-E or E-I magnetic core that can be used with three block coils.
Fig. 25 shows a rod-shaped magnetic core that can be used with a single block coil.
Figs. 26-31 show example substrates that can be used in the magnetic component of Fig. 1 and the electronic module of Fig. 3.
Fig. 32 is a top view of an electronic module with a gap in the magnetic core.
Fig. 33 shows an E-E or E-I magnetic core with gaps that can be used with three block coils.
Fig. 34 is a top perspective view of a block coil with four legs and a magnetic core mounted to the block coil.
Fig. 35 is a bottom perspective view of the block coil and the magnetic core of Fig. 34.
Fig. 36 is a side view of the block coil and the magnetic core of Fig. 34.
Fig. 37 is a top perspective view of another block coil with four legs and a magnetic core mounted to the block coil.
Fig. 38 is a bottom perspective view of the block coil and the magnetic core of Fig. 37.
Fig. 39 is a side view of the block coil and the magnetic core of Fig. 37.
Fig. 40 is a sectional view of a magnetic component including the block coil of Fig. 37 mounted to a substrate.
Fig. 41 is a top perspective view of a block coil in which a magnetic core is molded in the block coil.
Fig. 42 is a top perspective view of the block coil of Fig. 41 in which the block coil is transparent.
Figs. 43 and 44 are side views of the block coil of Fig. 41 in which the block coil is transparent.
Fig. 45 is a top perspective view of a terminal strip that can be used with the block coil of Fig. 41.
Fig. 46 is a top perspective view of the terminal strip of Fig. 45 with a magnetic core.
Fig. 47 is a top perspective view of another terminal strip that can be used with the block coil of Fig. 41.
Fig. 48 is a top perspective view of the terminal strip of Fig. 47 with a magnetic core.
Fig. 49 is a side perspective view of the terminal strip of Fig. 48 in which the magnetic core is transparent.

### DETAILED DESCRIPTION OF EXAMPLE EMBODIMENTS

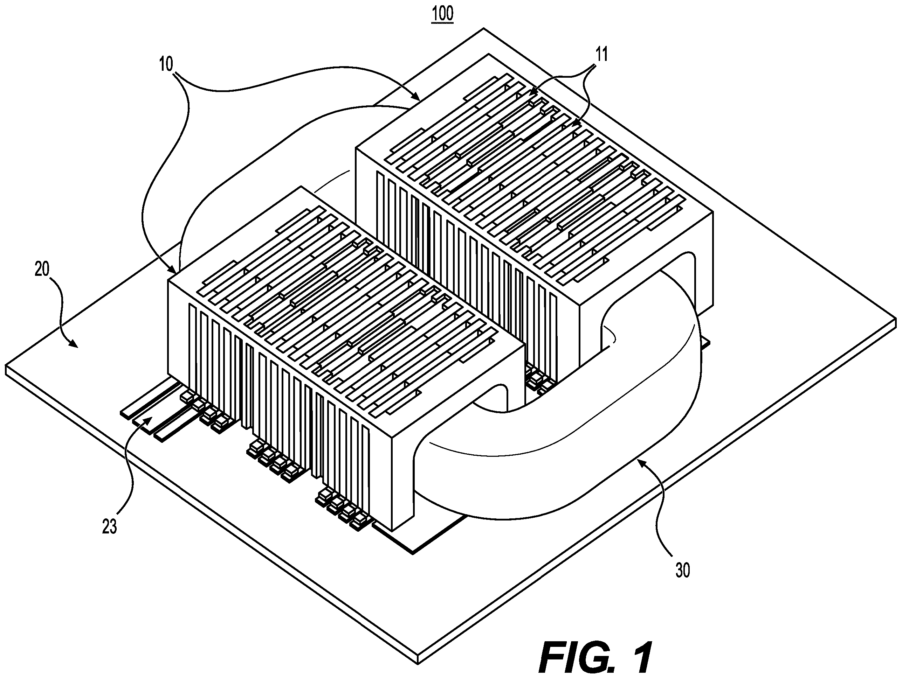

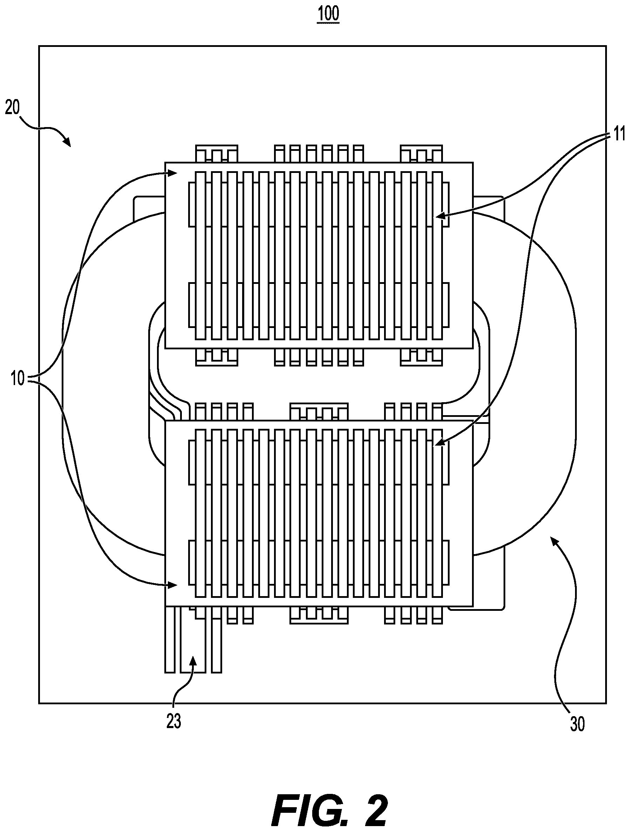

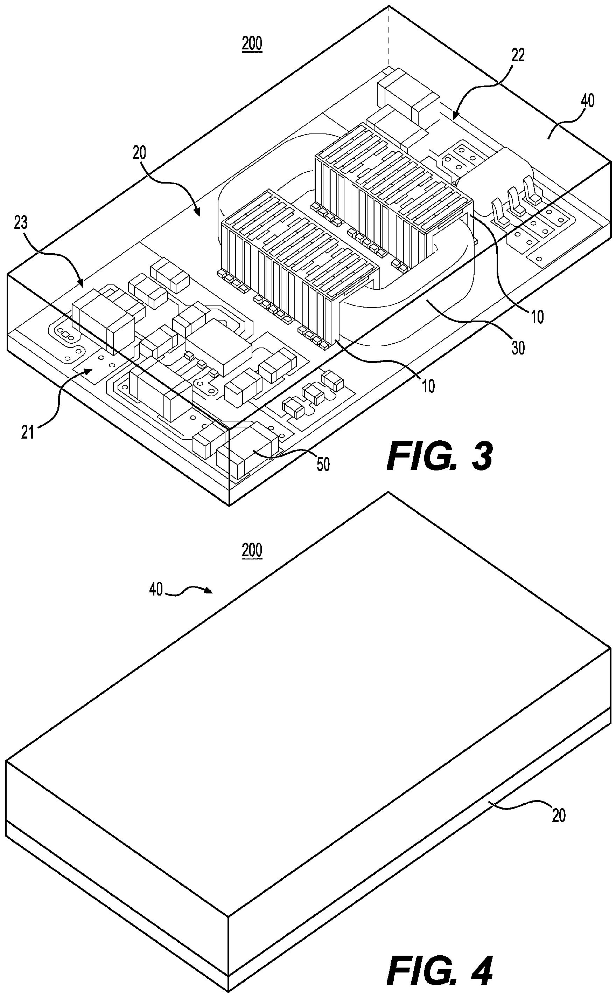

Figs. 1 and 2 shows a magnetic component 100 that includes a substrate 20, a magnetic core 30, and two block coils 10. Figs. 3-5 show an electronic module 200 that includes the magnetic component 100 of Fig. 1 and additional electronic component(s) 50. Although two block coils 10 are shown in Fig. 1-5, any number of block coils 10 can be used, including a single block coil 10.

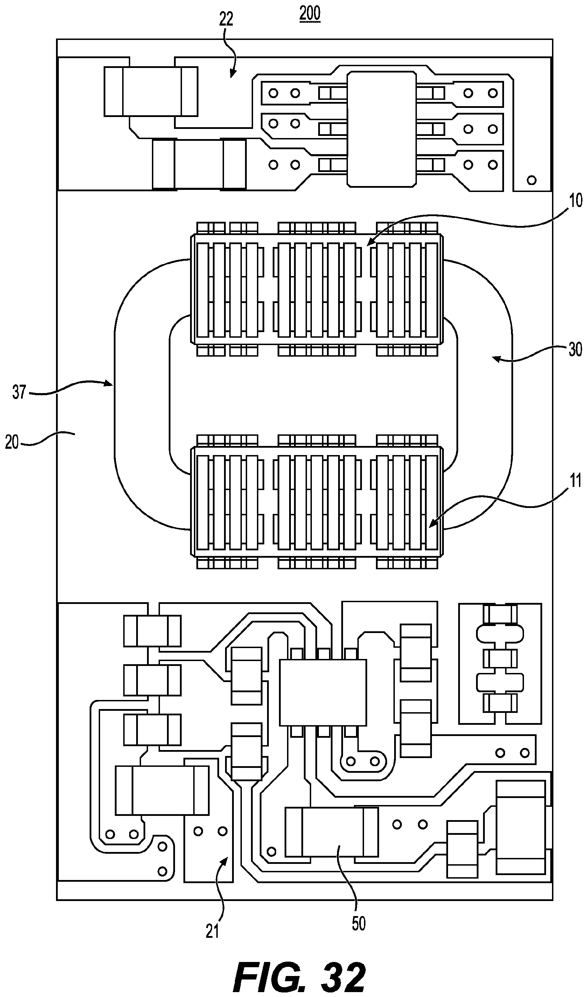

The magnetic component 100 can include one or more windings that wind around the magnetic core 30. For example, the magnetic component 100 can include a primary winding and a secondary winding that both extend around the magnetic core 30. Each winding can include one or more terminals 11 in a block coil or block coils 10 and can include one or more traces or conductive patterns 23 on or in the substrate 20. As shown in Fig. 32, the magnetic core 30 can include a gap 37.

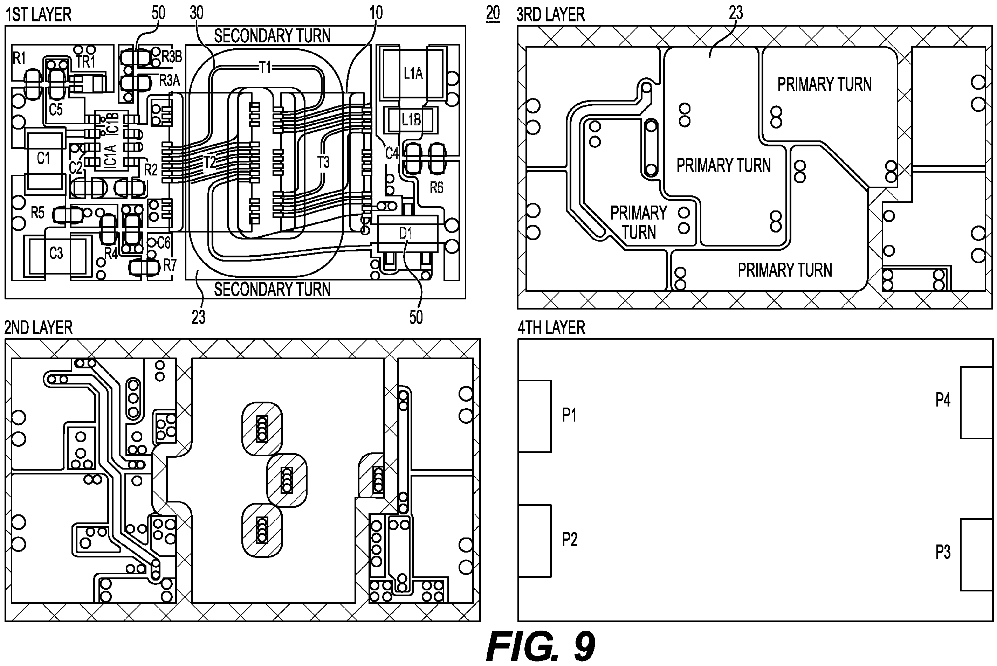

The substrate 20 can be any suitable substrate, including, for example, a printed circuit board (PCB). The substrate 20 can include a single layer or multiple layers and can include traces or conductive patterns 23 on an exterior surface (i.e., the top and the bottom surfaces) of the substrate 20 and/or in the substrate 20 (i.e., on an internal layer of the substrate 20). If the substrate 20 includes a single layer, then the traces or conductive patterns 23 of both the primary winding and the secondary winding can be located on the same layer, e.g., the top surface of the substrate 20. If the substrate 20 includes multiple layers, then the traces or conductive patterns 23 of the primary winding and the secondary winding can be located on the same layer or can be located on different layers. Fig. 9 shows four possible layers of the substrate 20. Although four layers are shown in Fig. 9, any number of layers can be used, including one layer.

As shown in Fig. 3 (in Fig. 3, the insulating material 40 is shown as transparent) and Fig. 4 (in Fig. 4, the insulating material 40 is not transparent), an insulating material 40 can be applied to the electronic module 200 to cover the substrate 20, the magnetic core 30, the two block coils 10, and any additional electronic component(s) 50. Any suitable insulating material 40 can be used, including, for example, a molding compound or an epoxy. The insulating material 40 can be applied in any suitable manner. The insulating material 40 can improve and help maintain isolation between the primary and the secondary circuit of the magnetic component 100. Insulating material 40 can also be applied to the magnetic component 100 of Fig. 1.

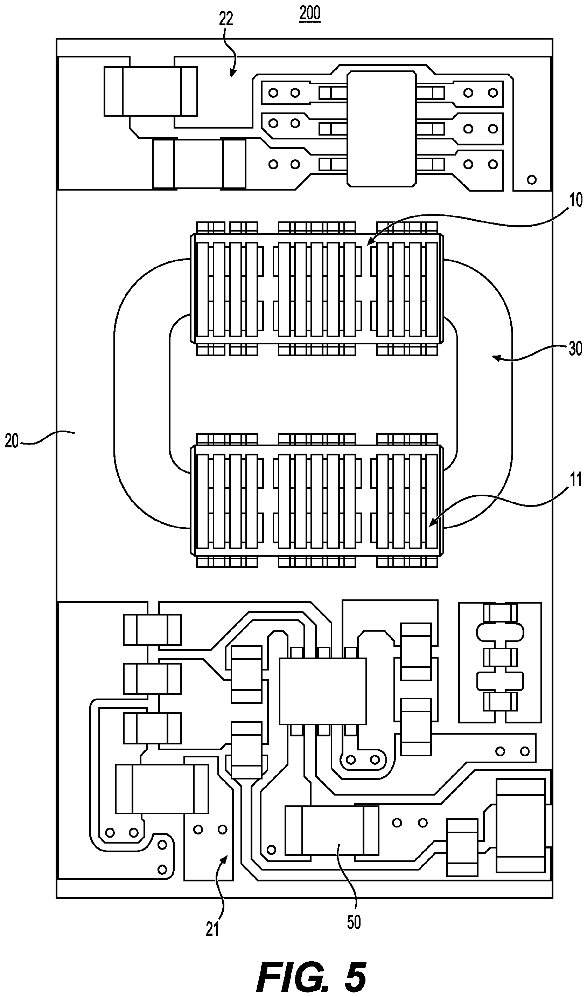

In Figs. 1 and 2, no additional electronic components 50 are shown on the substrate 20, but as shown for the electronic module 200 of Figs. 3 and 5, additional electronic component(s) 50 can be included on the substrate 20. The electronic component(s) 50 can be active components, such as transistors, integrated circuits (ICs), etc., or can be passive components, such as resistors, capacitors, inductors, etc. The electronic component(s) 50 can be connected to the same surface as the magnetic core 30 as shown in Figs. 3 and 5 and/or can be connected to the opposite surface as the magnetic core 30 (not shown). For example, locating capacitors on a surface of the substrate 20 opposite to the magnetic core 30 can contribute to (i) the "miniaturization" of electronic module 200 and (ii) prevent or greatly reduce short circuiting.

The electronic module 200 can be, for example, a power converter, isolator, or transformer, and the electronic components 50 can be the components of the power converter, isolator, or transformer. The electronic module 200 can be any suitable power converter, including, for example, a DC-DC converter or an AC-DC converter. For example, if the electronic module 200 is an isolated DC-DC converter, then, as shown in Figs. 3 and 5, electronic components 50 of a primary circuit 21 located on a first side of an isolation barrier can be located at one end of the substate, and electronic components 50 of a secondary circuit 22 located on a second side of the isolation barrier can be located at the opposite end of the substrate 20.

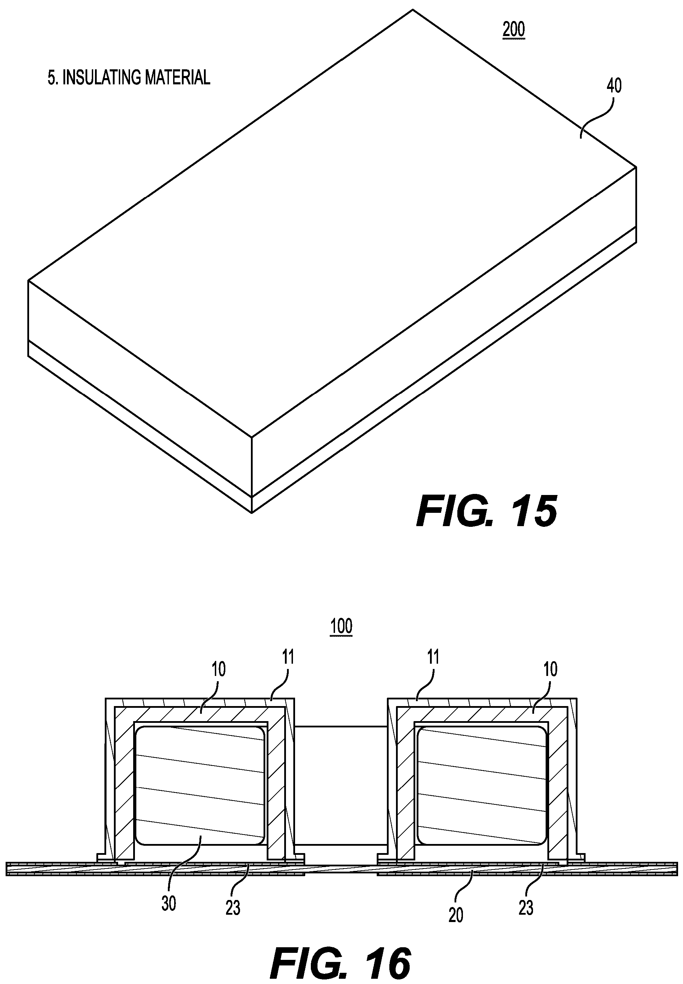

Fig. 16 shows a similar magnetic component 100 as Figs. 1 and 2, but the substrate 20 in Fig. 16 includes a single-layer substrate.

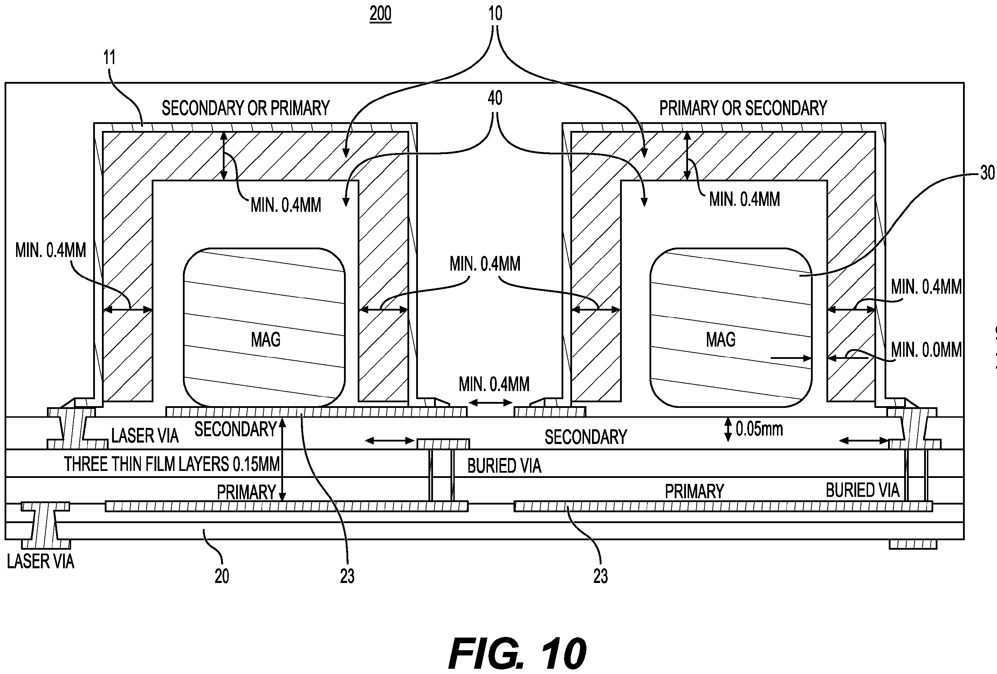

In Fig. 9, the 1^{st} layer of the substrate 20 shows the top surface of an electronic module 200 on which the magnetic core 30 can be located and to which the block coils 10 and the electronic components 50 can be attached. The 1^{st} layer can include traces or conductive patterns 23 that connect the electronic components 50. The traces 23 of the primary winding (i.e., primary traces or primary conductive patterns) and the traces 23 of the secondary winding (i.e., secondary traces or secondary conductive patterns) can be located on different layers of the substrate 20 as shown in Fig. 9 or can be located on the same layer of the substrate 20. For example, the primary traces 23 can be located on the 3^{rd} layer of the substrate 20, and the secondary traces 23 can be located on the 1^{st} layer. The primary traces 23 and the secondary traces 23 can be separated by one or more layers. In Fig. 9, the primary traces 23 and the secondary traces 23 are separated by the 2^{nd} layer of the substrate 20. In the cross-sectional view of Fig. 10, the primary traces 23 and the secondary traces 23 are separated by three thin film layers for a total separation of 0.15 mm. The hatched areas in Fig. 9 are keep-out areas, but other keep-out area arrangements are also possible. For example, the area on the 1^{st} layer between the feet 12 of the terminals 11 of the block coils 10 can also be a keep-out area, which as shown in Fig. 10 includes a keep-out area with a minimum width of 0.4 mm between the block coils 10. The outer layer of the substrate 20 can include input/output (I/O) terminals P1, P2, P3, P4 that can be used to connect the electronic module 200 to a host substrate (not shown). I/O terminals P1, P2 can be connected to an input voltage, and I/O terminals P3, P4 can provide an output voltage.

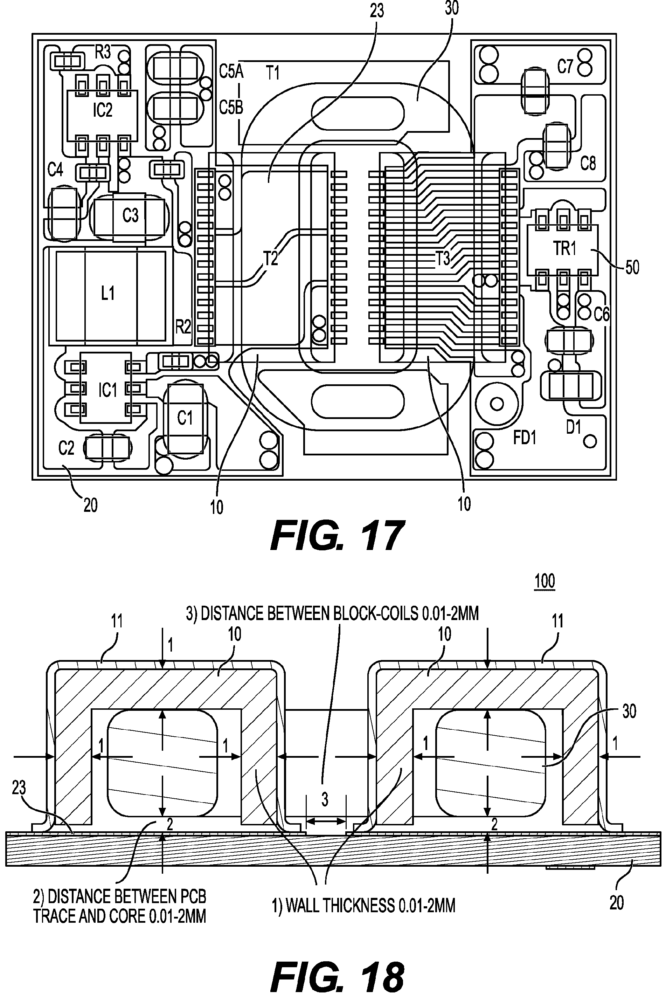

As shown in Fig. 9, one or more terminals 11 of each block coils 10 can be connected to a trace 23. For example, in one of the block coils 10, a single secondary trace 23 can connect a foot of one secondary terminal 11 to a foot of another secondary terminal 11 to define a single turn of the secondary winding, or in one of the block coils 10, a primary trace 23 can connect the feet 12 of three primary terminals 11 to the feet 12 of three other primary terminals 11 to define a single turn of the primary winding. That is, it is possible for a single turn of a winding to include one or more terminals 11 connected by a single trace 23. Fig. 17 shows a possible circuit arrangement of an electronic module 200 including either (a) a single-layer substrate 20 or (b) a multi-layer substrate 20 in which the electronic component(s) 50 and all of the traces 23 are on the top surface of the substrate 20. As in Fig. 9, one or more terminals 11 of each block coil 10 can be connected to a trace 23. The traces 23 on the substrate 20 can determine how many terminals 11 are included in a single turn and can determine how many turns are in either the primary or the secondary winding. Thus, the same block coil 10 can be used in different applications, which can save design costs because a different block coil 10 does not have to be made for each application.

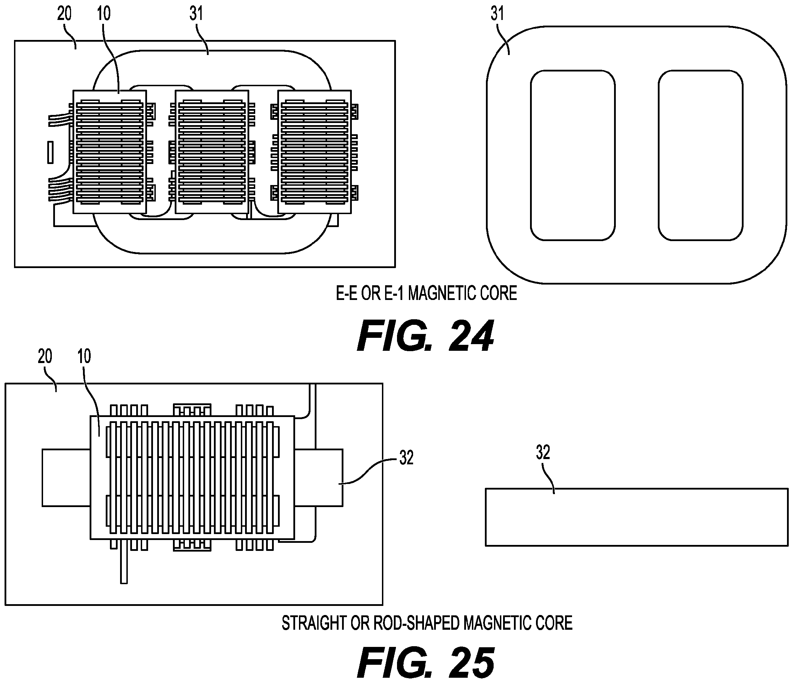

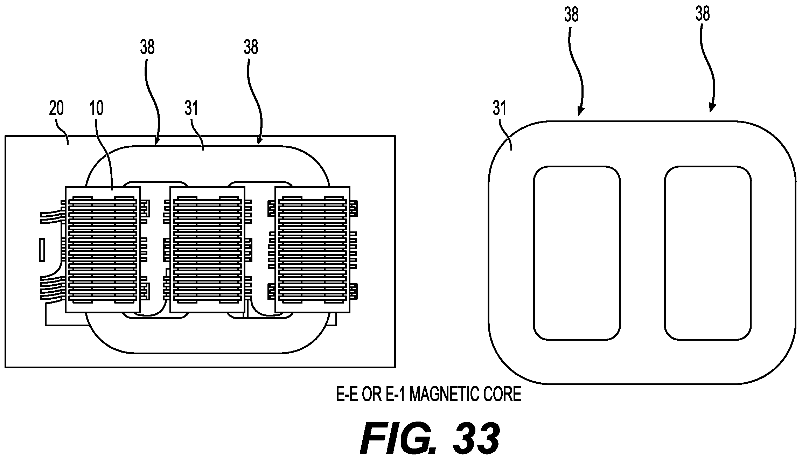

The magnetic core 30 can have any suitable shape including the ring shape shown in Figs. 1-3 and 5 or other suitable shapes such as E-I or E-E magnetic core 31 as shown in Fig. 24, a straight or rod-shaped magnetic core 32 as shown in Fig. 25, oval-shaped magnetic core, non-round magnetic core, irregular shaped magnetic core (not shown), etc. The magnetic core 30, 31, 32 can include any suitable magnetic material, including, for example, ferrite. The magnetic core 30, 31, 32 can be coated or uncoated. Coating the magnetic core 30, 31, 32 can improve isolation. The coating can be any suitable material, including, for example, epoxy resin, polyimide, etc. The magnetic core 30, 31, 32 can be attached to the substrate 20 or the block coil(s) 10. If the magnetic core 30, 31, 32 is attached the block coil(s) 10, then the magnetic core 30, 31, 32 can be attached to an inner, upper surface of the block coil(s) 10. As shown in Fig. 32, the magnetic core 30 can include a gap 37, and as shown in Fig. 33, the magnetic core 31 can include two gaps 38. Although one gap 37 is shown in Fig. 32 and two gaps 38 are shown in Fig. 33, any number of gaps can be used. The magnetic core 30, 31 can be manufactured with the gap(s) 37, 38, or after the magnetic core 30, 31 is manufactured, the gap(s) 37, 38 can be made in the magnetic core 30, 31, for example, by cutting or sawing.

One or more gaps 37, 38 can be used in some applications, including, for example, in DC-DC or AC-DC converters, to control the inductance of the magnetic core 30, 31. The gaps 37, 38 shown in Figs. 32 and 33 are air gaps that increase the power handling capability of the magnetic core 30, 31 by delaying core saturation. Core saturation can cause the magnetic core 30, 31 to lose its magnetic properties.

The position of the gaps 37, 38 in relation to the winding(s), including terminals 11 in the block coil(s) 10, can affect performance of the converter. If the gap 37, 38 is close to the winding(s), including the terminals 11 of the block coil(s) 10, then a phenomenon known "fringing-effect" can cause eddy currents to be induced in the winding(s), including the terminals 11 in the block coil(s) 10, which can result in power loss. Thus, as shown in Figs. 32, and 33, because the gap 37, 38 can be spaced away from the winding(s), there is limited effect caused by the fringing fields, reducing power loss. Because the gap's 37, 38 position can be accurately controlled, power loss can be consistently reduced.

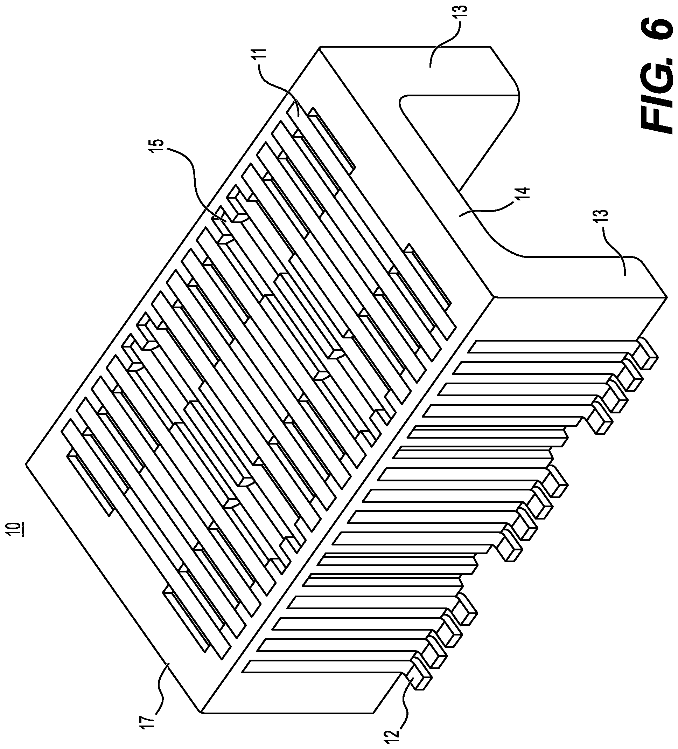

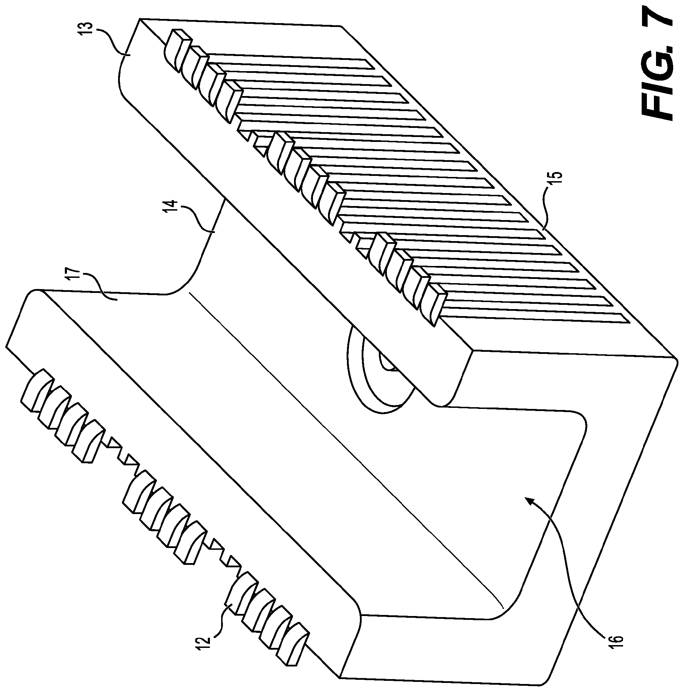

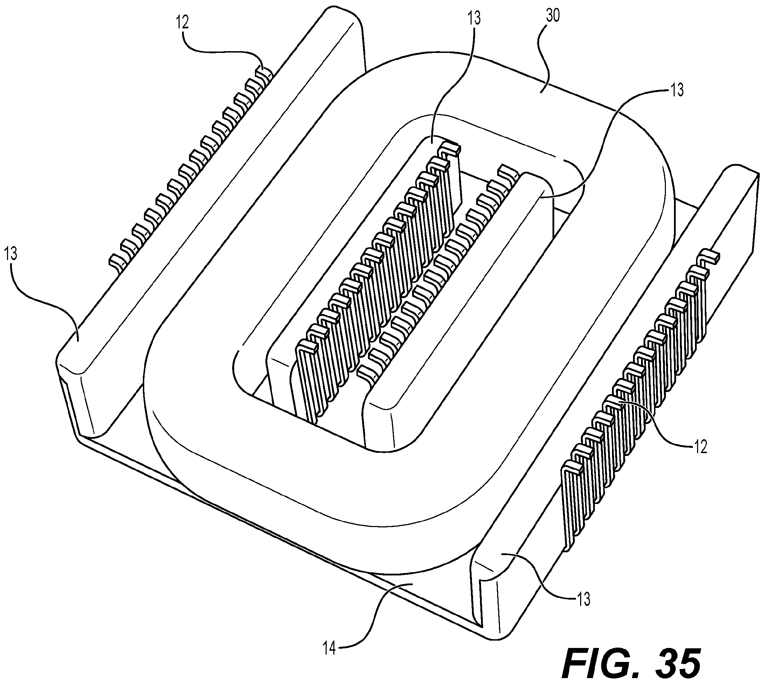

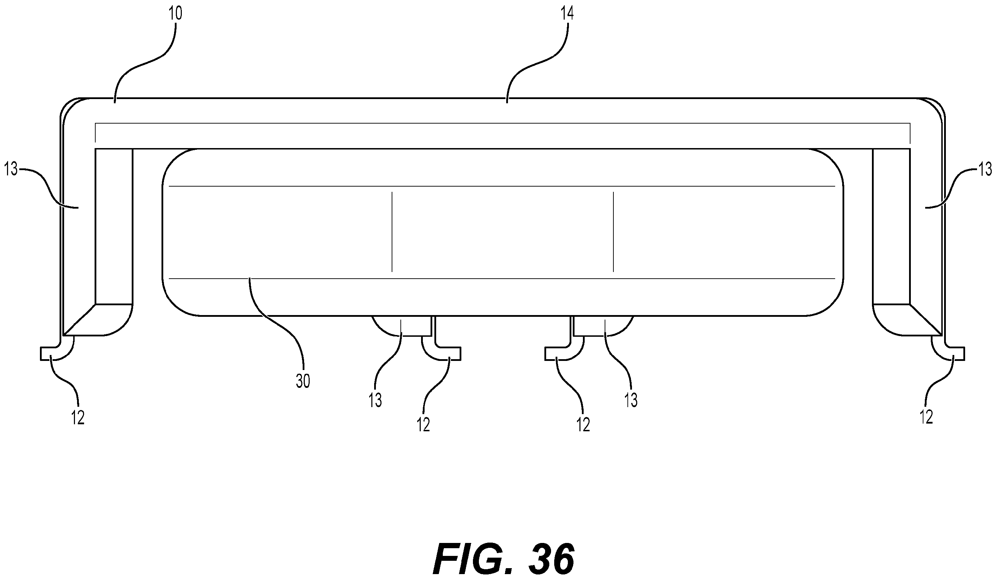

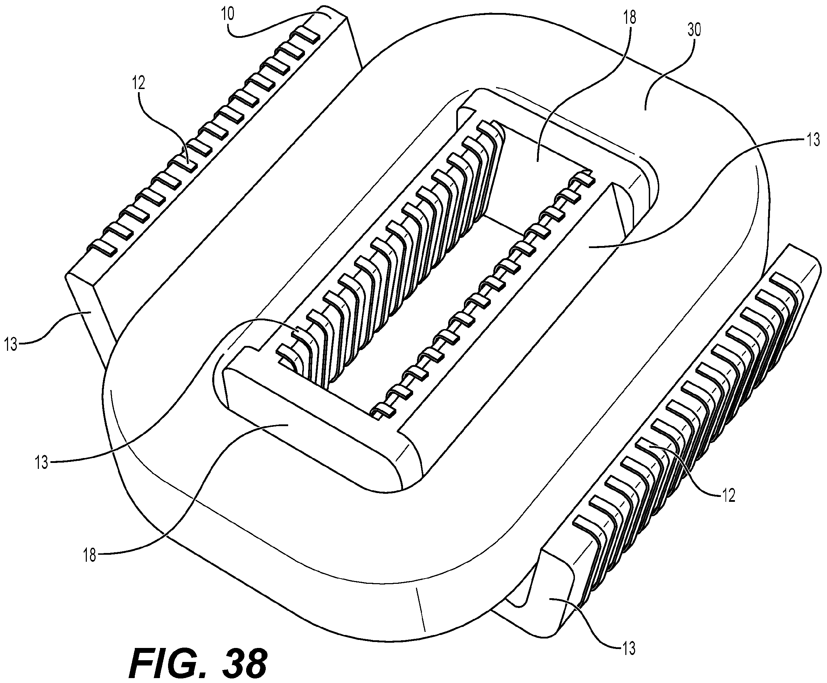

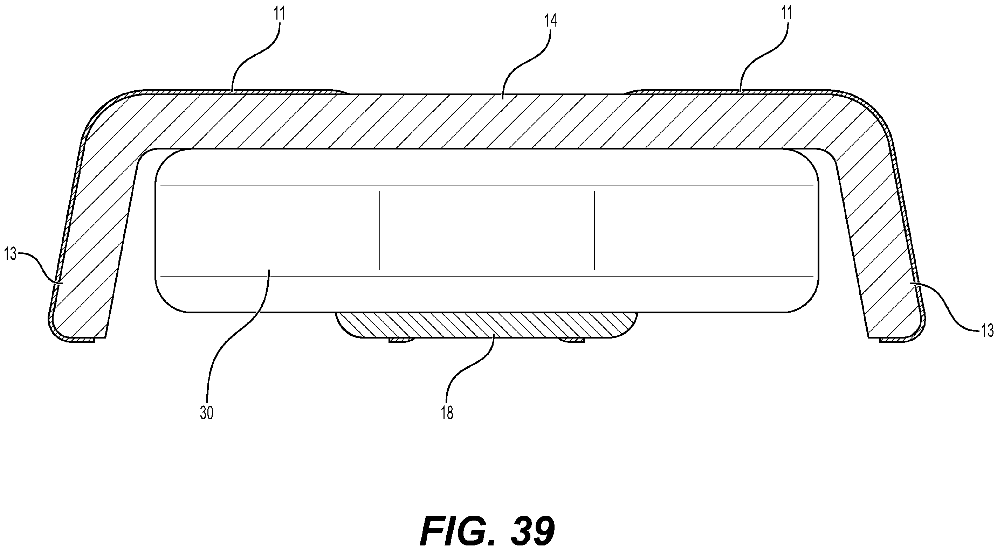

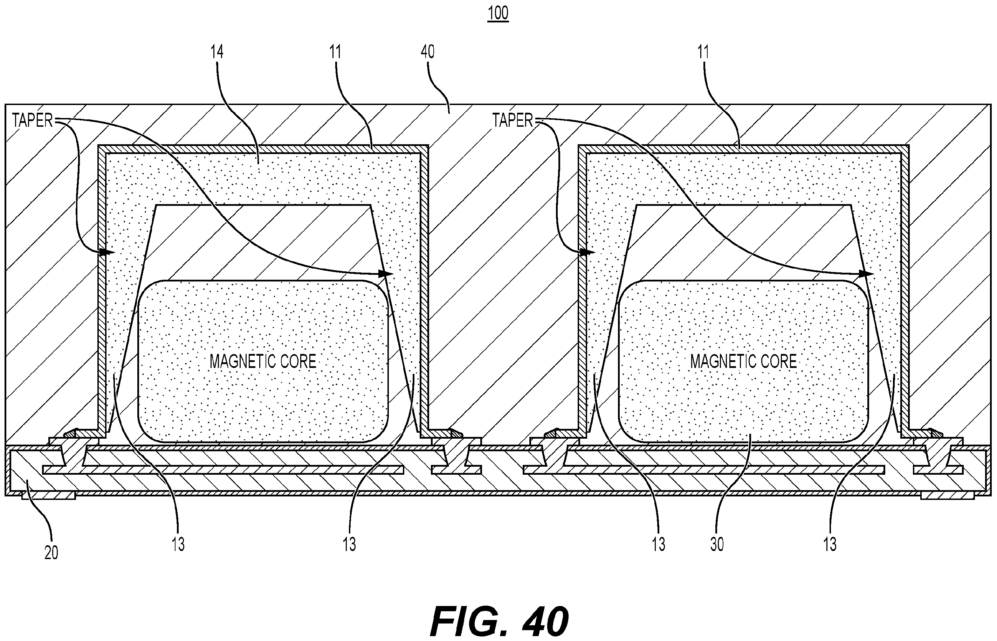

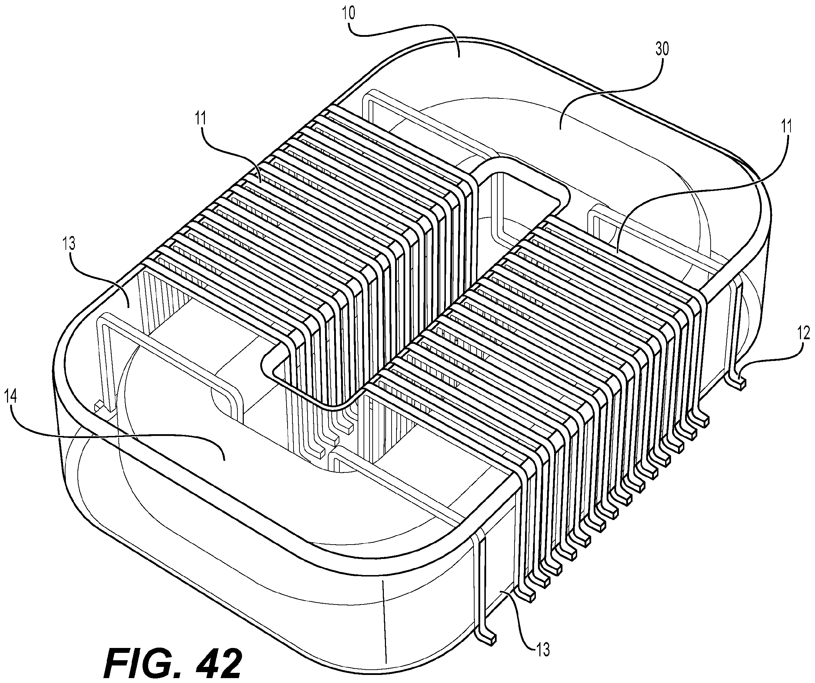

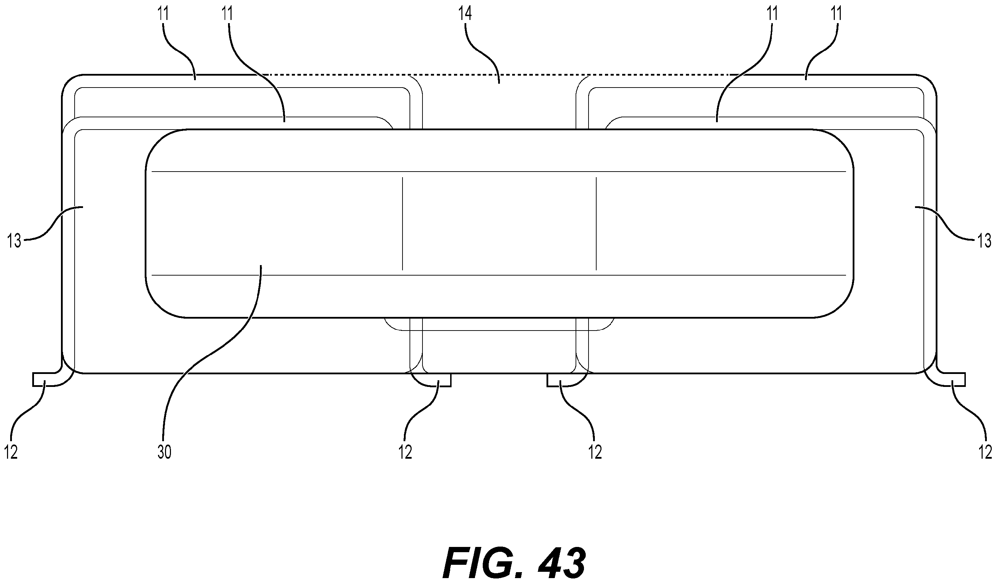

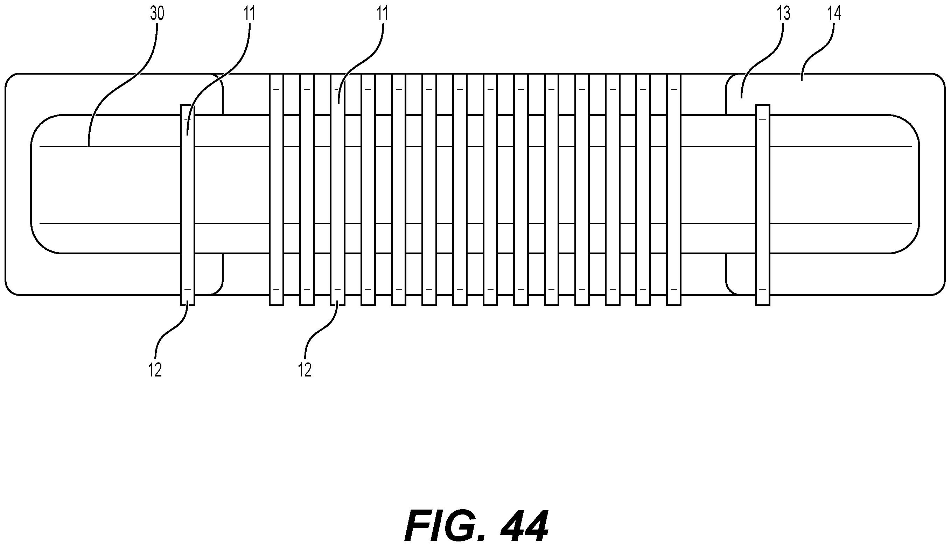

Figs. 6, 7, and 34-44 show examples of the block coil 10. The block coil 10 can include a resin body 17 and terminals 11. As shown in Figs. 6 and 7, the resin body 17 can include two legs 13 connected by a bridge 14 to define a cavity or groove 16 that receives a portion of the magnetic core 30.

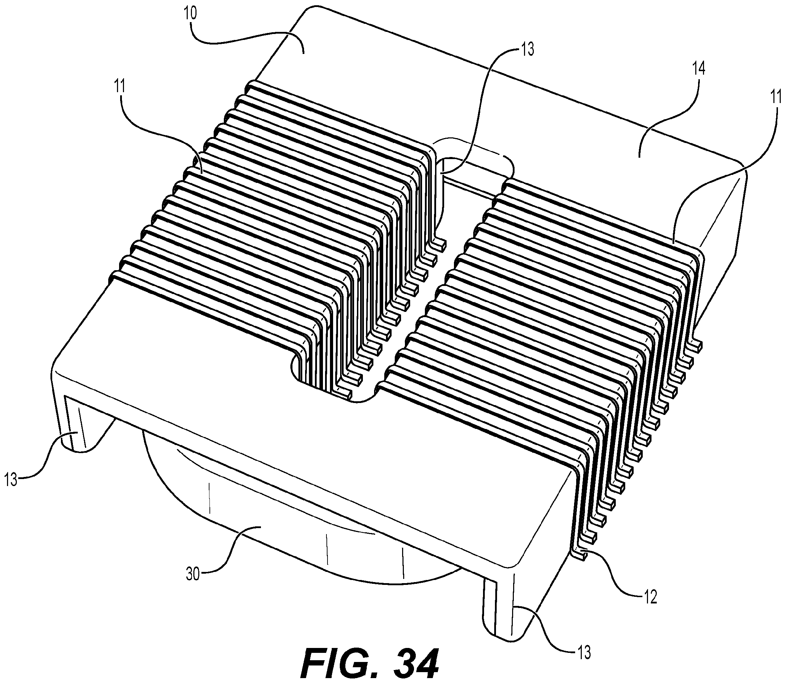

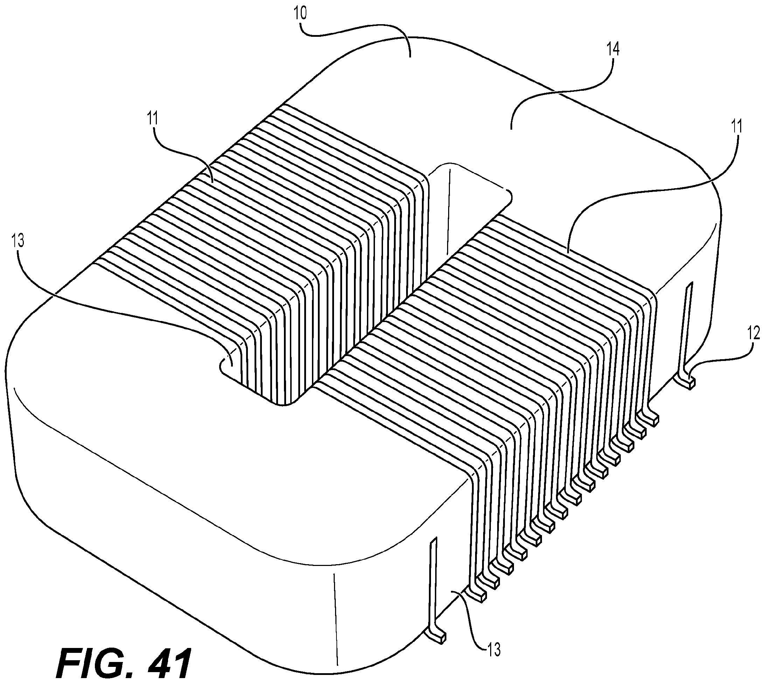

Although Figs. 6, 7, and 41-44 show two legs 13 extending from the bridge 14, it is possible to have a different number of legs 13 extending from the bridge 14. The block coil 10 of Figs. 41-44 can be molded such that the legs 13 extend from the bridge 14 and are connected underneath the magnetic component. As shown in Figs. 34-40, four legs 13 can extend from the bridge 14. In other words, Figs. 34-40 show a block coil 10 in which two block coils 10 of Figs. 6 and 7 are connected by the bridge 14 to be combined into a single unitary component. The block coil 10 in Figs. 34-40 can include a monolithic body that is defined by the four legs 12, the bridge 14, and the protrusions 18 in that the four legs 12, the bridge 14, and the protrusions 18 can be made of the same material. The terminals 11 can be connected to and/or held by the monolithic body.

As shown in Figs. 6, 7, and 37-39, the legs 13 can have the same length or substantially the same length within manufacturing and/or measurement tolerances, or as shown in Figs. 34-36, the legs 13 can have different lengths. In Figs. 41-44, the circumference of the outer leg 13 is longer than the circumference of the inner leg 13.

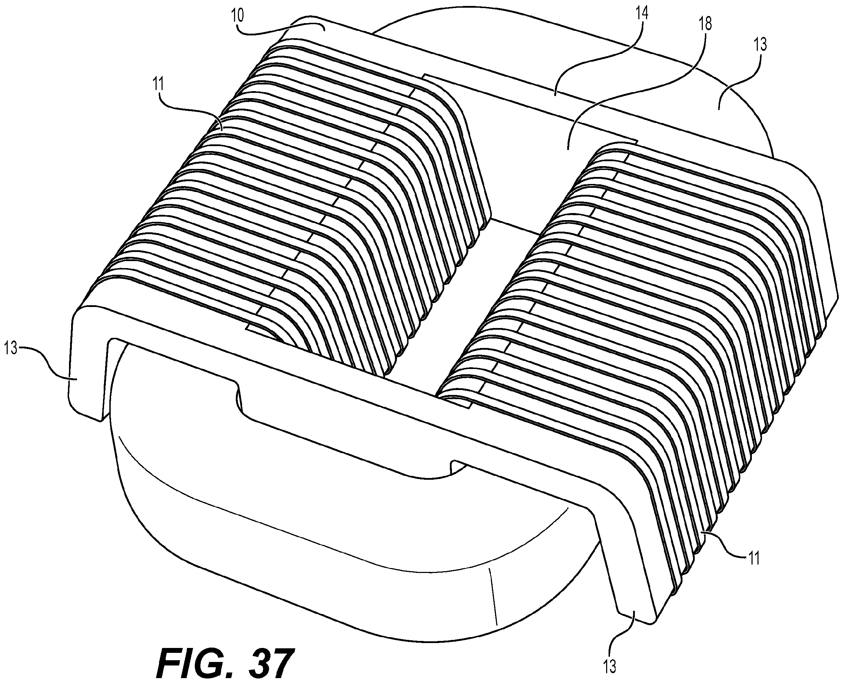

The resin body 17 can define a U-shape or can have any suitable shape such that the resin body 17 extends over or bridges the magnetic core 30. The resin body 17 can extend over three sides of a cross section of the magnetic core 30. As shown in Figs. 6, 7, 37-36, and 41-44, the legs can be straight, i.e., perpendicular or substantially perpendicular within manufacturing and/or measurement tolerances, with respect to the bridge 14, or as shown in Figs. 37-39, the legs 13 can be tilted, i.e., the legs 13 are not perpendicular with the bridge 14, such that the resin body 17 defines a tapered portion. As shown in Figs. 37-39, the bridge 14 can include protrusions 18 that extend into the hole of the magnetic core 30.

In Figs. 6 and 7, the resin body 17 can be open, i.e., the resin body 17 can include openings at the ends of the resin body 17, so that the block coil 10 extends over only a portion of the magnetic core 30. The block coil 10 can have a different shape than the magnetic core 30. For example, as shown in Figs. 1 and 2, the block coil 10 can have a linear or rectangular shape, while the magnetic core 30 can have a circular or toroidal shape. Alternatively, as shown in Figs. 41-44, the resin body 17 can be closed, i.e., the resin body 17 defines a loop without ends, so that the block coil 10 extends over the entire magnetic core 30. Even if the resin body 17 is closed to define a loop as described above, the resin body 17 can include an opening in the bottom so that the resin body 17 can be placed over the magnetic core 30. The block coil 10 and the magnetic core 30 can have the same or similar shapes. For example, as shown in Figs. 41-44, the block coil 10 and the magnetic core 30 can have a circular or toroidal shape.

The resin body 17 can include slots 15 in which the terminals 11 can be located or embedded in and can define a flat pick-up surface that a pick-and-place machine can use to precisely place the block coil 10 on a substrate 20 in one motion. That is, multiple turns of the winding(s) can be created with one motion. In addition, the block coil 10 provides a structure that protects the terminals 11 and prevents or greatly reduces any chance of short-circuiting. Because the resin body 17 allows different arrangements of terminals 11 to be used with the same resin body 17, the same resin body 17 can be used in different applications, which can save design costs because a different resin body 17 does not have to be made for each application. For example, if the resin body 17 is made by a molding process, then the same mold can be used for different applications, saving design costs. In Figs. 6 and 7, the slots 15 in the resin body 17 are visible, but in the finished product, the slots 15 may not be visible, for example, if a resin mold is used that fills the gaps in the slots 15.

The resin body 17 can be made of any suitable insulating material, including, for example, liquid crystal polymer (LCP) resin, and can be made in any suitable manner. The terminals 11 can be made of any suitable conductive material, including, for example, copper or copper alloy.

In Figs. 41-44, the resin body 17 is molded around the terminals 11 and the magnetic core 30. The terminals 11 can be embedded in the resin body 17 or exposed on the top surface of the resin body 17, and the magnetic core 30 can be either fully or partially embedded in the resin body. In Figs. 41-44, the magnetic body 30 is fully embedded in the resin body 17 such that resin body 17 extends underneath the magnetic body 30. When the block coil 10 with the fully embedded magnetic core 30 is mounted to a substrate, the magnetic body 30 does not directly contact the substrate because the resin body 17 extends underneath the magnetic core 30. The magnetic core 30 can be elevated above the substrate to satisfy any safety requirements. The magnetic core 30 can be insulated or uninsulated. If the magnetic core 30 is insulated, then the magnetic core 30 can be in direct contact with the terminals 11 when the resin body 17 is molded around the magnetic core 30 and the terminals 11.

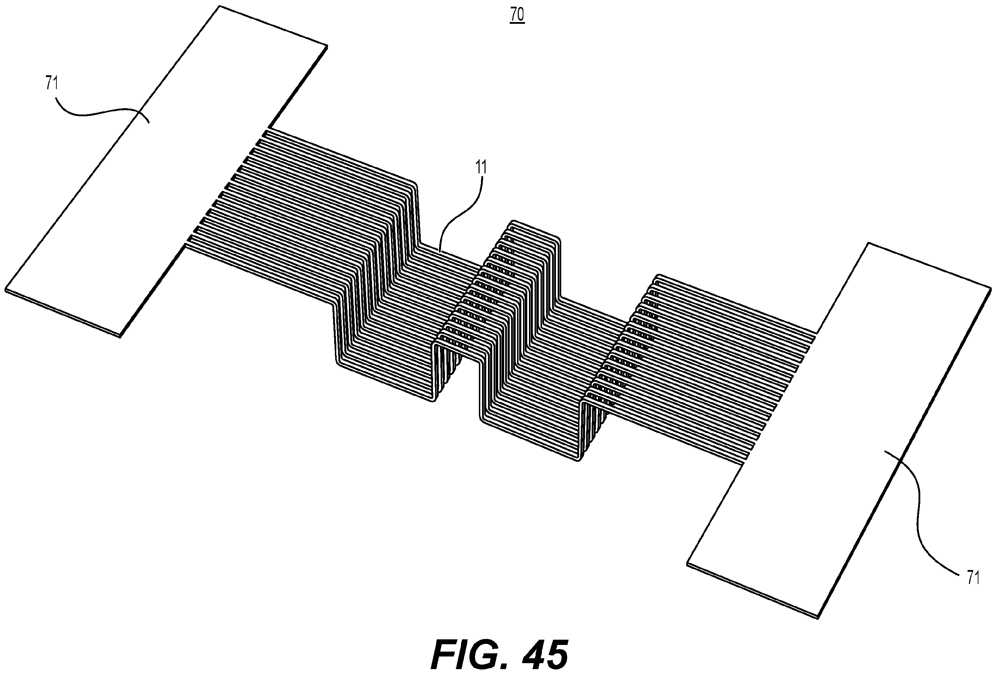

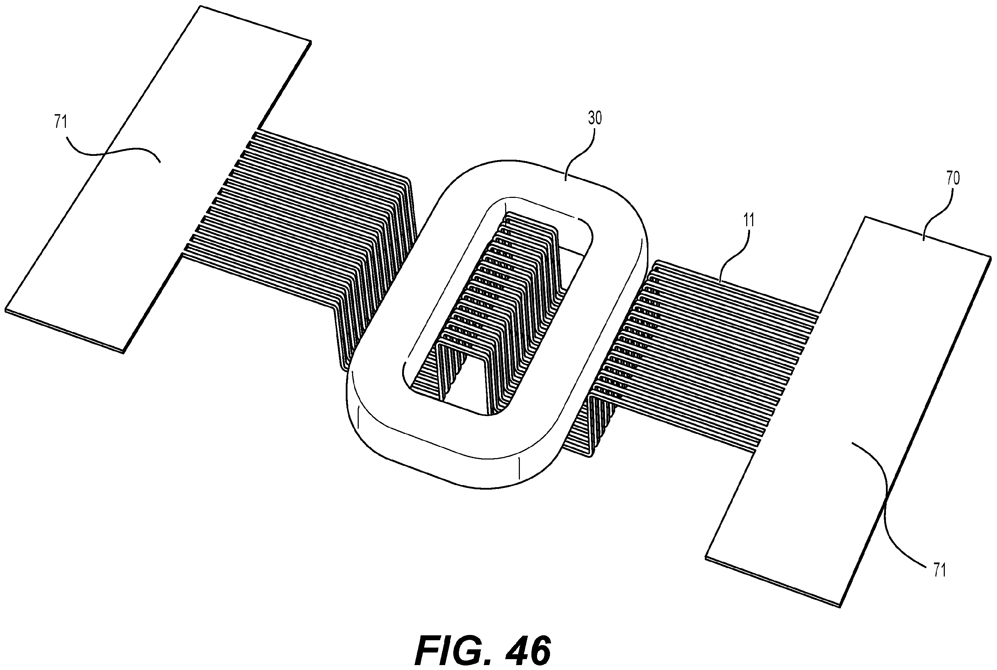

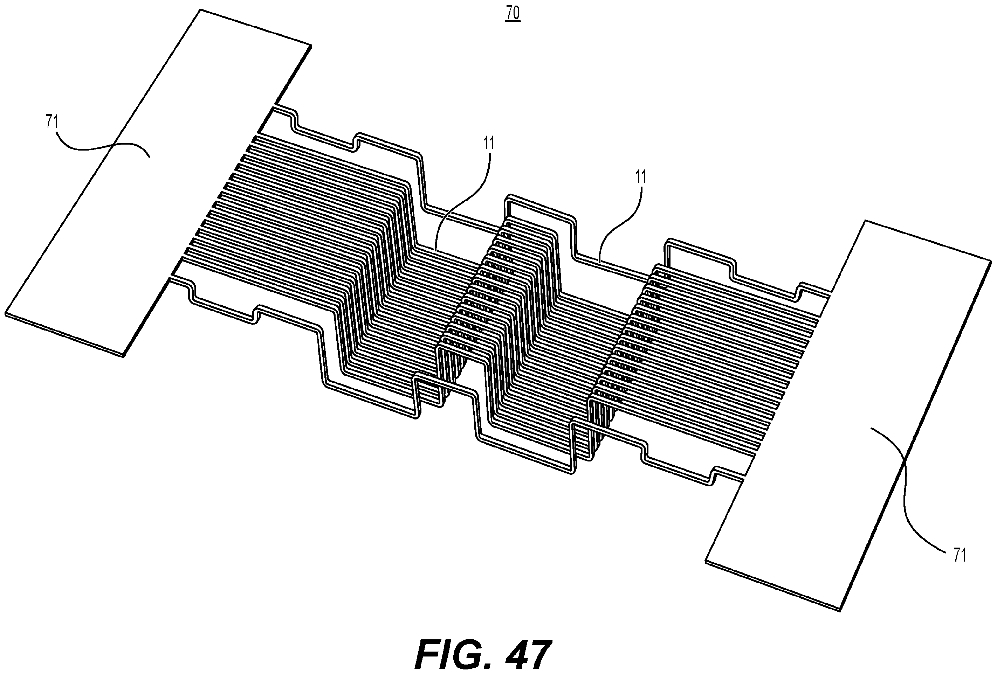

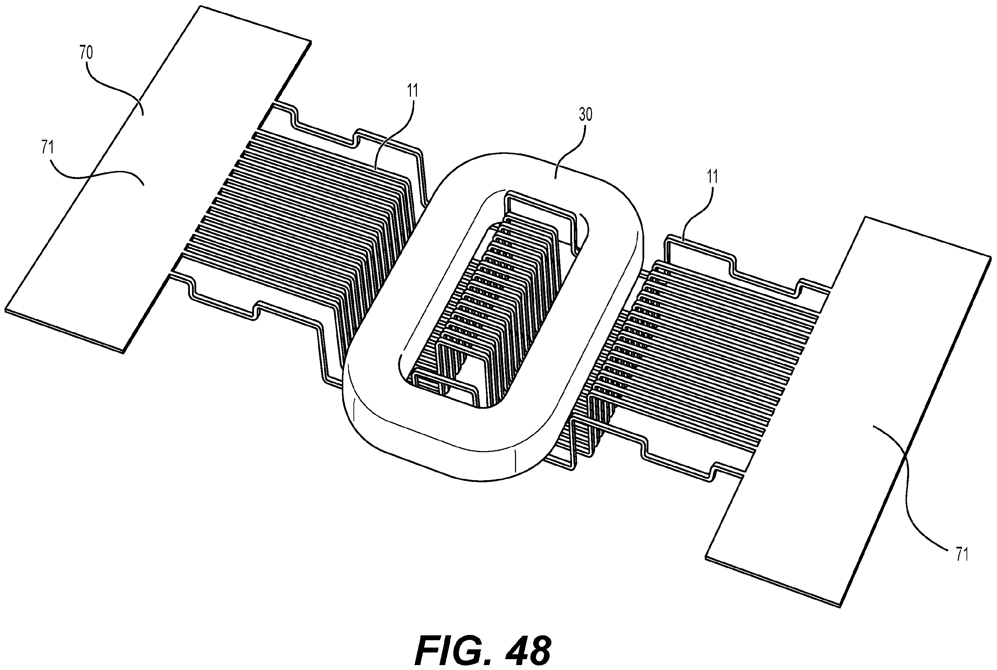

Figs. 45-49 show terminal strips 70 that can be used when the resin body 17 is molded around the magnetic core 30 and the terminals 11. The terminal strips 70 include a plurality of terminals 11 that are connected by tabs 71 located at opposing ends of the terminal strip 70. In Figs. 45 and 46, the terminals 11 are the same or substantially the same within manufacturing and/or measurement tolerances, and in Figs. 47-49, the terminals 11 include two placement terminals that are used to determine location of the magnetic core 30 within the resin body 17. In Figs. 47 and 48, the two placement terminals are the first and last terminals 11, but any number and any arrangement of placement terminals can be used.

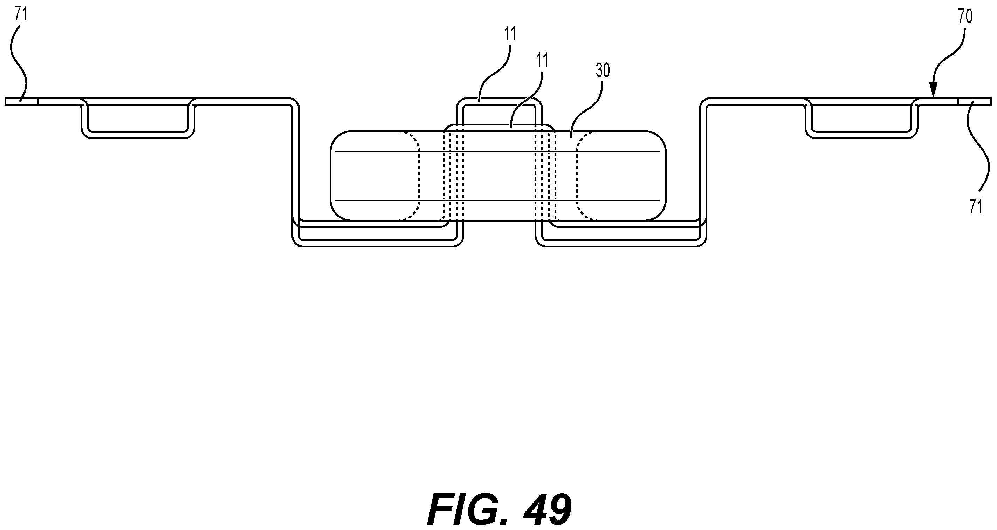

The terminals 11 in the terminal strip 70 have a W-shape in which each terminal 11 includes two indentations on opposite sides of a protrusion. As shown in Figs. 46 and 48, the magnetic core 30 can be placed on the terminal strip 70 such that the magnetic core 30 rests on the indentations and such that the protrusions of the terminals 11 extend into the hole of the magnetic core 30. As shown in Fig. 49, the placement terminals can have shallower indentations and shorter protrusions so that when the magnetic core 30 is placed on terminal strip 70, the magnetic core 30 is held above the other terminals 11. Because all of the terminals 11 must initially have the same length, additional indentation(s) can be included in the placement terminals.

The resin body 17 can be molded around the magnetic core 30 and the terminals 11 in Figs. 46 and 48. After the resin body 17 is formed, a portion of the protrusion of the terminals 11 can be removed to form the feet 12 in the interior of the hole of the magnetic core 30, and portions of the terminals 11 on the exterior of the resin body 17 can be removed to form the feet 12 on the exterior of the magnetic core 30. The removal of the portions of the terminals 11 creates two terminals 11, one on each side of the hole of the magnetic core 30. Because the protrusion of the placement terminals is embedded in the resin body, the protrusion may not be removed, which results in a single terminal 11 that extends from one side of the magnetic core 30, into the hole of the magnetic core 30, and to the other side of the magnetic core 30.

The block coil 10 of Figs. 6 and 7 can require that the magnetic core 30 be positioned and fixed in place before multiple block coils 10 are positioned over the magnetic core 30, as shown, for example, in Figs. 1 and 5. The magnetic core 30 can be surface-mount-assembly (SMA) placed/glued to a substrate, and then the block coils can be SMA placed over the magnetic core 30 on the substrate. This multi-step process can add to costs and a buildup of design/manufacturing tolerances that should be factored into the design of the electronic module, typically increasing the footprint size of the electronic module. In addition, isolation requirements between the windings must be carefully considered when the magnetic core 30 directly touches the substrate where the windings are present, typically resulting in a more complex/costly substrate stack-up.

In Figs. 34-40, the magnetic core 30 can be attached to the block coil 10, and in Figs. 41-44, the magnetic core 30 can be embedded in the resin body 17. The magnetic core 30 in Figs. 34-40 can be clipped and/or glued to the block coil 10. The block coils of Figs. 34-44 can therefore be made as a single unitary component that is quicker, easier, and cheaper to manufacture. The single unitary component in Figs. 34-40 can include a monolithic body with the four legs 12, the bridge 14, and the protrusions 18 being made of the same material. The terminals 11 can be connected to and/or held by the monolithic body. The block coil 10 of Figs. 34-40 can position the magnetic core 30 above the substrate so that a simpler, more cost-effective substrate design can be used. When the block coil 10 is mounted to a substrate, the block coil 10 can position the magnetic core 30 at a predetermined distance above the substrate, including, for example, a distant that meets a safety requirement. The magnetic core 30 in Figs. 41-44 is embedded in the resin body 17, isolating the magnetic core 30 from the substrate, which also allows for the use of a simpler, more cost-effective substrate design. The magnetic core 30 in Figs. 41-44 can be either fully embedded or partially embedded in the resin body 17. The magnetic core 30 can be insulated or can be uninsulated. If the magnetic core 30 is insulated, then the magnetic core 30 can be in direct contact with a lead frame, and if the magnetic core 30 is uninsulated, the magnetic core 30 can be spaced away from the lead frame.

Fig. 6 shows twelve terminals 11 and four empty slots 15. Any number of terminals 11 can be used, including, for example, 14, 16, 18, 20, or more than 20 terminals. The terminals 11 can have a U-shape as shown in Fig. 6 and 7 or can have any suitable shape such that the terminals 11 extend over or bridge the magnetic core 30. The terminals 11 can extend over three sides of a cross section of the magnetic core 30. The terminals 11 can include feet 12 that can be surface mounted to the substrate 20. Alternatively, the terminals 11 can be connected to the substrate 20 in any suitable manner. The feet 12 of the terminals 11 can be attached to the substrate 20 such that the block coil 10, including the resin body 17, is located on or above the substrate 20. The terminals 11 can be located or embedded in slots 15 in the block coil 10. As shown in Fig. 6, not all of the slots 15 have to have a corresponding terminal 11. In Fig. 6, four slots 15 do not have a corresponding terminal 11, but any number of slots 15 could be empty. Fig. 6 shows sixteen slots 15, but any number of slots 15 could be used.

The terminals 11 in the block coil 10, along with traces 23 on or in the substrate 20, can be included in the windings of the magnetic component 100. If the windings include primary windings and secondary windings, then some terminals 11 can be included in the primary winding and be connected to primary traces 23, and some terminals 11 can be included in the secondary winding and be connected to secondary traces 23. Alternatively, all of the terminals 11 in the block coil 10 either can be included in the primary winding and be connected to primary traces 23 or can be included in the secondary winding and be connected to secondary traces 23. If all of the terminals 11 in one block coil 10 are included in the primary winding, then all of the terminals 11 in another block coil 10 can be included in the secondary winding, and vice versa. If all of the terminals 11 in one block coil 10 are included in the primary winding, then another block can include terminals 11 in both the primary winding and the secondary winding, and vice versa.

The terminals 11 in a block coil 10 can be included in groups. Which terminal group each terminal 11 belongs to is determined by the traces 23 on the substrate 20. For example, with one substrate 20, all of the terminals 11 might belong to a first terminal group, while with another substrate 20, the adjacent terminals 11 might be in two different terminal groups, either a first terminal group or a second terminal group. For example, Fig. 6 shows two terminal groups, i.e., first and second terminal groups. In Fig. 6, the first terminal group includes four first terminals 11 on each end of the block coil 10, and the second terminal group includes four second terminals 11 in the middle of the block coil 10 in between the first terminals 11 of the first terminal group. Other arrangements are also possible. For example, the first and second terminals 11 can alternate along the length of the block coil 10 such that each terminal 11 of one terminal group can be between two terminals 11 of the other terminal group. Alternatively, the terminal groups do not have to be split. That is, the terminals 11 of the first terminal group can be located on one end of the block coil 10 (e.g., seven first terminals 11 on one end), and the terminals 11 of the second terminal group can be located on the other end of the block coil 10 (e.g., seven second terminals 11 on the other end with two slots 15 in the middle without any terminals 11). The terminals 11 can also be arranged in a bifilar arrangement in which two windings are arranged next to each other. For example, adjacent terminals 11 can be connected to either a first primary winding or a second primary winding.

Each terminal 11 of the first or the second terminal group can be closer to an adjacent terminal 11 of the same group than a terminal 11 of the other group. That is, each first terminal 11 can be closer to another first terminal 11 than any second terminal 11, and each second terminal 11 can be closer to another second terminal 11 than any first terminal 11. Slots 15 between adjacent terminal groups can be empty (i.e., the number of terminals 11 can be reduced or thinned) to help improve isolation between the first and second terminal groups. More empty slots 15 between adjacent terminal groups can increase the isolation between the terminal groups. The adjacent terminal groups can be spaced away from each other. Instead of including empty slots 15, adjacent terminal groups can be spaced farther apart from each other than adjacent terminals 11 in a terminal group. For example, adjacent terminal groups can be spaced apart twice the distance that adjacent terminals 11 in a terminal group are spaced part, with no empty slots 15 between the adjacent terminal groups.

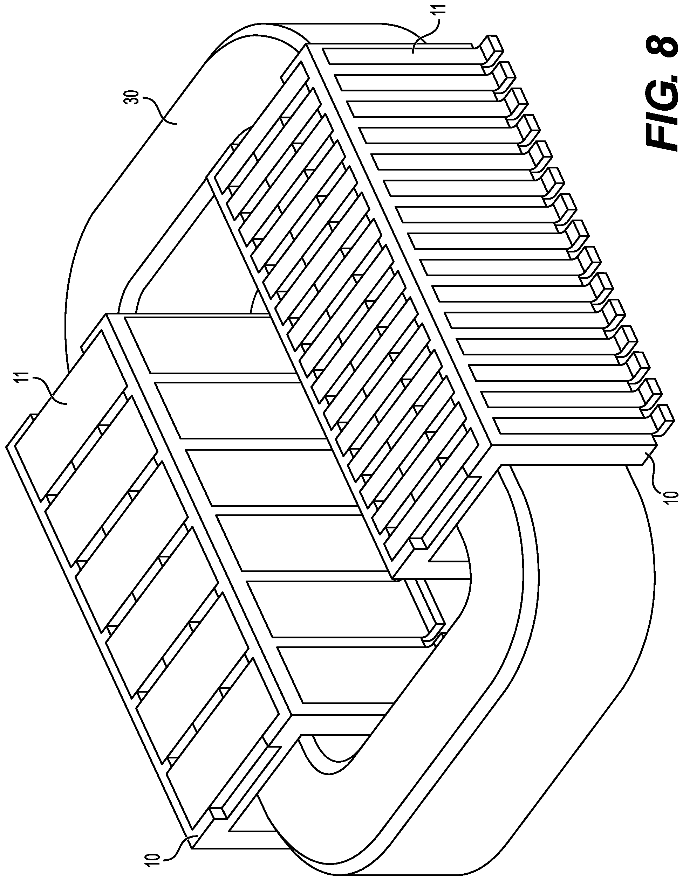

Fig. 8 shows two block coils 10 with terminals 11 with different widths. As shown in Fig. 8, the terminals 11 of each block coil 10 can have the same width. Alternatively, the terminals 11 with different widths can be included in the same block coil 10.

Fig. 10 shows the cross-section of two block coils 10 connected to a multi-layer substrate 20. Fig. 10 shows various minimum distances that ensure adequate isolation. For example, the walls of the resin body 17 should be at least 0.4 mm thick so that the terminals 11 are at least 0.4 mm from the cavity or groove 16 within the block coil 10. If the magnetic core 30 is coated, then 0.4 mm wall thickness can be reduced, for example, to 0.2 mm. The isolation distance will depend on the application. The minimum distance between the magnetic core 30 and the walls of the resin body 17 can be 0.0 mm so that there is no distance between the magnetic core 30 and the walls of the resin body 17. On the surface of substrate 20, the minimum distance between the traces or conductive patterns 23 of the primary and secondary circuits should be at least 0.4 mm.

As shown in Fig. 10, the substrate 20 can include laser vias that can be created by laser and that do not have to extend all the way through the substrate 20 and can include buried vias that extend between internal layers of the substrate 20 but that do not extend the external surfaces of the substrate 20. Each of the multiple layers of the substrate 20 can be 0.05 mm or approximately 0.05 mm within manufacturing and/or measurement tolerances. As shown in Fig. 10, the primary traces 23 and the secondary traces 23 can be separated by three internal layers such that the total distance between the primary traces 23 and the secondary traces 23 is at least 0.15 mm to ensure adequate isolation. Although a minimum distance of 0.4 mm between the primary and the secondary circuits is required on the surface of a substrate 20, the minimum distance between the primary and the secondary circuits inside of the substrate 20 depends on isolation requirement of each product. Other distances are also possible. For example, in Fig. 18, distance 1 is the thickness of the walls of the block coil 10 and can be about 0.01 mm to about 2.0 mm, within manufacturing and/or measurement tolerances; distance 2 is the distance between the trace 23 on the top layer of the substrate 20 and the magnetic core 30 and can be about 0.01 mm to about 2.0 mm, within manufacturing and/or measurement tolerances; and distance 3 is the smallest distance between the between the block coils 10 (which is the distance between the feet 12 of the terminals 11 in Fig. 18) and can be about 0.01 mm to about 2.0 mm, within manufacturing and/or measurement tolerances.

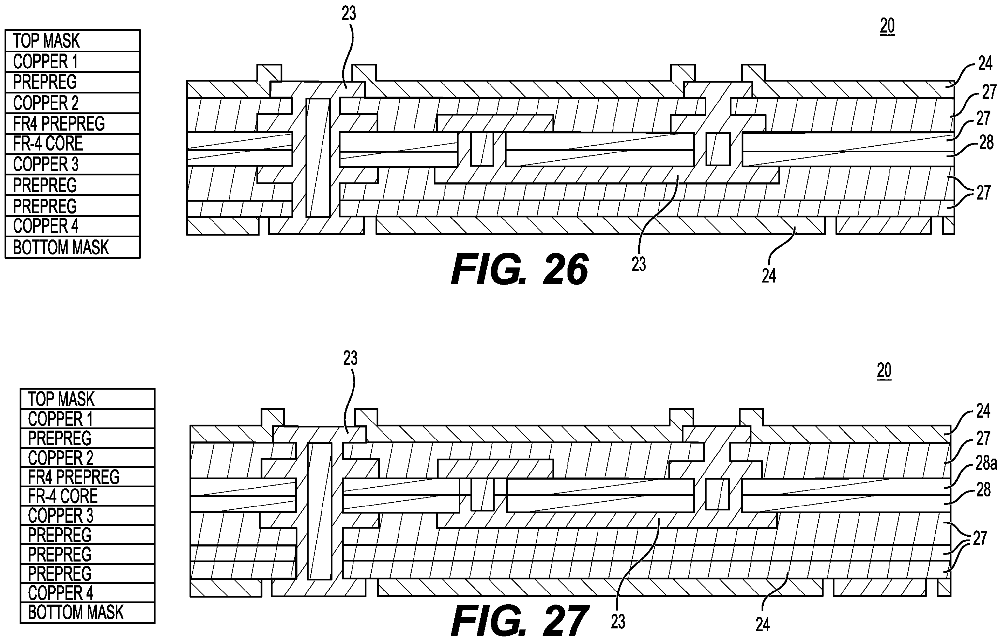

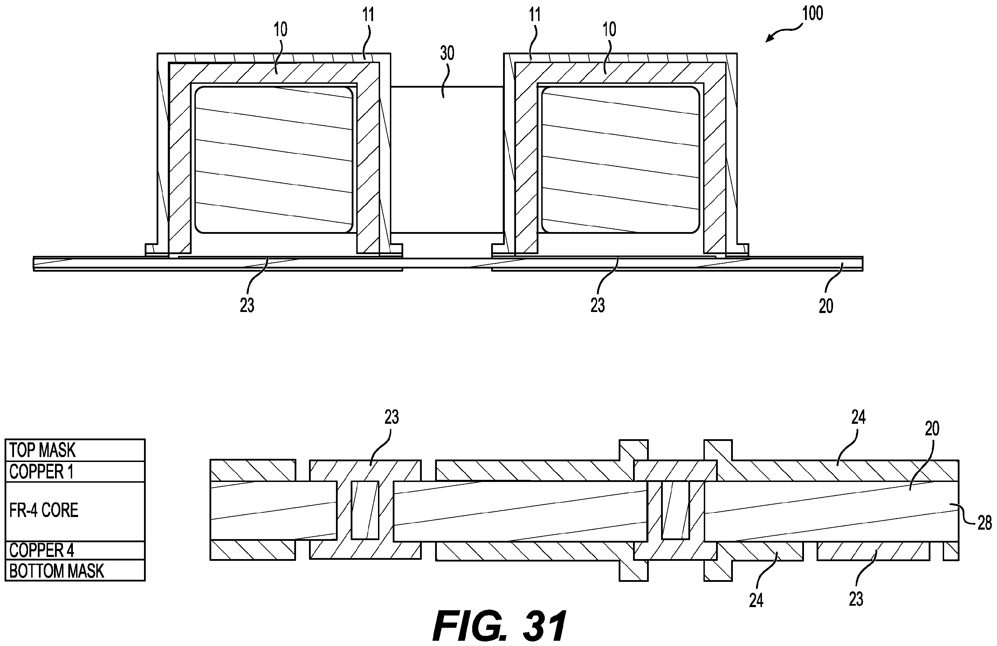

Figs. 26-31 show different possible substrates 20 that can be used in either a magnetic component 100 or in an electronic module 200. Figs. 26-30 show different possible multi-layer substrates 20, while Fig. 31 shows a single-layer substrate 20. As shown in Figs. 26-30, the substrate 20 can include multiple layers, including a top mask 24, one or more pre-preg layers 27, a core layer 28, one or more pre-preg layers 27, and a bottom mask 24. The core layer 28 can also include a core pre-preg layer 28a. The core layer 28 can include any suitable material, including, for example, FR-4. Traces 23 can be included on the top and bottom surfaces of the substrate 20 and can be included in interior layers of the substrate 20. The traces 23 on different layers can be connected by vias. The vias can include a hole in the substrate 20 that is plated with a conductive material, including, for example, a metal or metal alloy, and filled with any suitable material, including, for example, a resin. Alternatively, the vias can be filled with only conductive material. The vias can be made in any suitable manner, including, for example, mechanical drilling or laser drilling. Any suitable vias can be used, including, buried vias in which neither side of the vias is exposed on the top or bottom surface of the substrate 20, blind vias in which one side of the vias is exposed on the top or bottom surface of the substrate 20, and through-hole vias in which both sides of the vias are exposed on either the top or the bottom surface of the substrate 20. The traces 23 can include copper or other suitable conductive material. Similarly, as shown in Fig. 31, the substrate 20 can include a single layer, including a top mask 24, a core layer 28, and a bottom mask 24. The traces 23 in Fig. 31 can be located on the top or the bottom surfaces of the substrate 20.

Fig. 26 shows a multi-layer substrate 20 that includes a top mask 24, a pre-preg layer 27, a core pre-preg layer 28a, a core layer 28, two pre-preg layers 27, and a bottom mask 24. Traces 23 are located on the top and bottom surfaces of the substrate 20, the top surface of the core pre-preg layer 28a, and the bottom surface of the core layer 28.

Fig. 27 shows a multi-layer substrate 20 that includes a top mask 24, a pre-preg layer 27, a core pre-preg layer 28a, a core layer 28, three pre-preg layers 27, and a bottom mask 24. Traces 23 are located on the top and bottom surfaces of the substrate 20, the top surface of the core pre-preg layer 28a, and the bottom surface of the core layer 28.

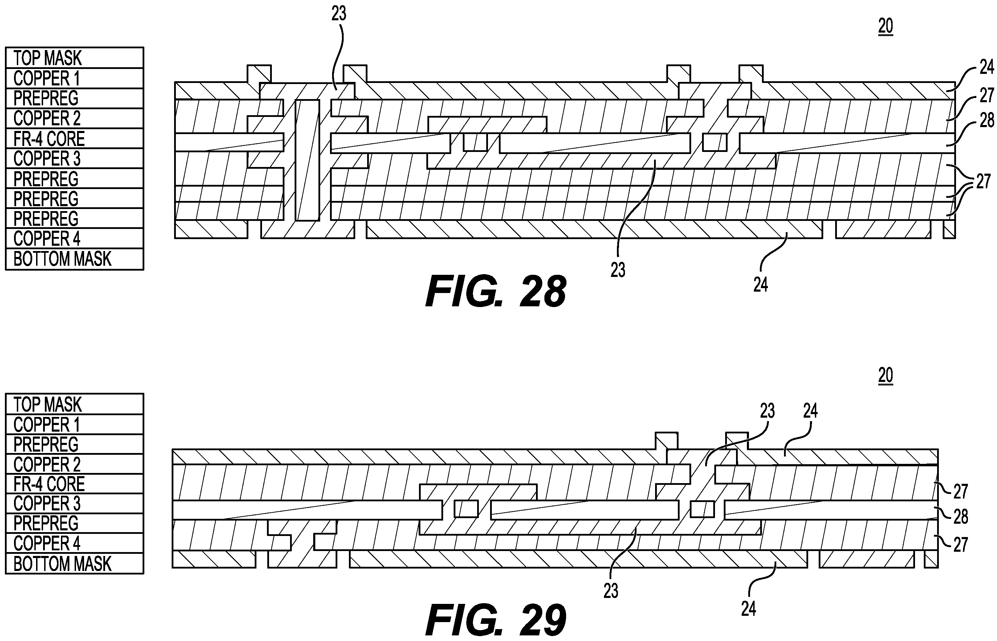

Fig. 28 shows a multi-layer substrate 20 that includes a top mask 24, a pre-preg layer 27, a core layer 28, three pre-preg layers 27, and a bottom mask 24. Traces 23 are located on the top and bottom surfaces of the substrate 20 and the top and bottom surfaces of the core layer 28.

Fig. 29 shows a multi-layer substrate 20 that includes a top mask 24, a pre-preg layer 27, a core layer 28, a pre-preg layer 27, and a bottom mask 24. Traces 23 are located on the top and bottom surfaces of the substrate 20 and the top and bottom surfaces of the core layer 28.

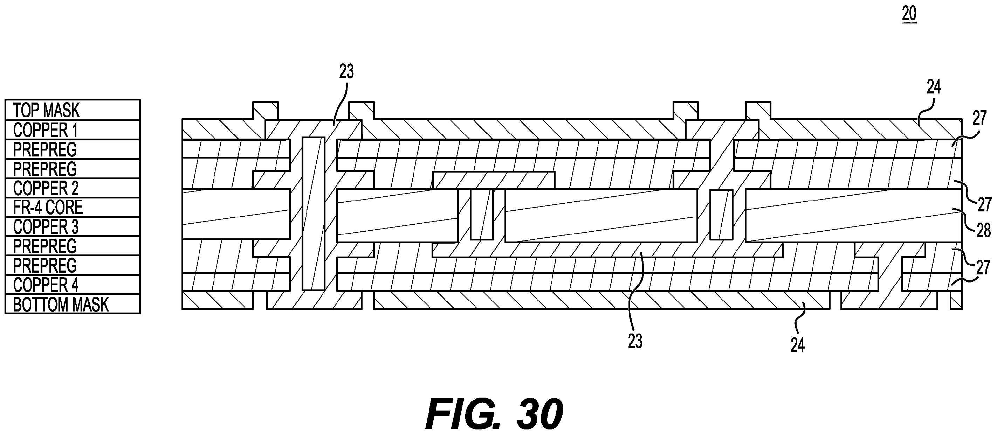

Fig. 30 shows a multi-layer substrate 20 that includes a top mask 24, two pre-preg layers 27, a core layer 28, two pre-preg layers 27, and a bottom mask 24. Traces 23 are located on the top and bottom surfaces of the substrate 20 and the top and bottom surfaces of the core layer 28.

The multi-layer substrate in Figs. 26-30 makes it easier to locate the primary and the secondary traces or conductive patterns 23 and to provide insulation between the primary and the secondary traces or conductive patterns 23. If multiple block coils 10 are used, then the multi-layer substrate in Figs. 26-30 can make it easier to provide isolation between the primary and the secondary traces or conductive patterns 23.

The bottom portion of Fig. 31 shows a single-layer substrate 20 that includes a top mask 24, a core layer 28, and a bottom mask 24. Traces 23 are located on the top and bottom surfaces of the substrate 20. The top portion of Fig. 31 shows a magnetic component 100 including two block coils 10 mounted to the single-layer substrate 20 and including a magnetic core 30. The traces 23 are on the top surface of the single-layer substrate 50. The single-layer substrate 20 allows for a smaller magnetic component 100 or electronic module 200. As an example, one of the block coils 10 can include primary terminals 11 and the other block coils 10 can include secondary terminals 11 so that primary traces 23 connected to the primary terminals 11 and the secondary traces 23 connected to the secondary terminals can be located on the same surface of the substrate 10.

As shown in Fig. 10, portions of the secondary traces 23 and the primary traces 23 can overlap vertically, which can improve coupling between the primary and the secondary windings. The larger the overlap between the primary and the secondary windings, the larger the coupling between the primary and the secondary windings. The resistance can be lowered if primary traces 23 or if the secondary traces 23 are located on adjacent layers. That is, the resistance can be lowered in the primary winding if primary traces 23 on different layers are only separated by a single layer, and the resistance can be lowered in the secondary winding if secondary traces 23 on different layers are only separated by a single layer.

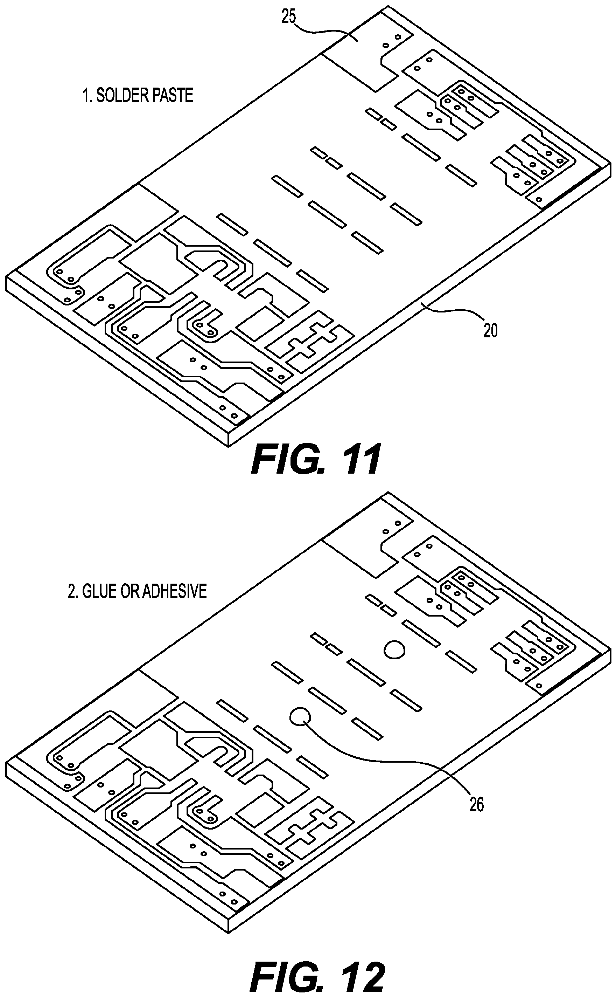

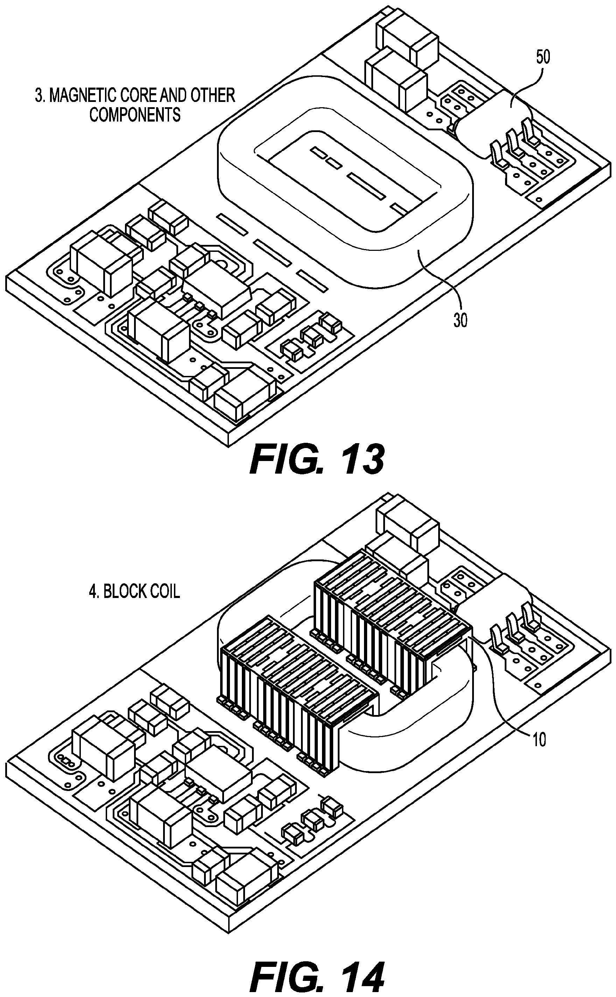

Figs. 11-15 show a method of making an electronic module 200 with block coils 10 mounted to a substrate 20. Fig. 11 shows providing a substrate 20 and them applying solder paste 25. The substrate 20 can be one of the substrates 20 discussed above and can be multi-layer or single-layer substrate. Fig. 12 shows glue or adhesive 26 being dispensed on the substrate 20. The glue or adhesive 26 can be dispensed as part of a surface mount technology (SMT) process or separate from an SMT process. Fig. 13 shows the placement of the magnetic core 30 and the electronic component(s) 50. Fig. 14 shows the placement of two block coils 10 that extend over or bridge the magnetic core 30. Fig. 15 shows insulating material 40 covering the substrate 20, the electronic component(s) 50, the magnetic core 30, and the block coils 10. Fig. 15 shows that the insulating material 40 covers the entire substrate 20, but the insulating material 40 can cover only a portion of the substrate 40 and/or cover only one or some of the electronic component(s) 50, the magnetic core 30, and the block coils 10. Typically, a mother substrate can be used in which an array of electronic modules 200 are included in the mother substrate. The mother substrate is then diced or singulated to form individual electronic modules 200. Alternative, individual electronic module 200 can be manufactured without using a mother substrate.

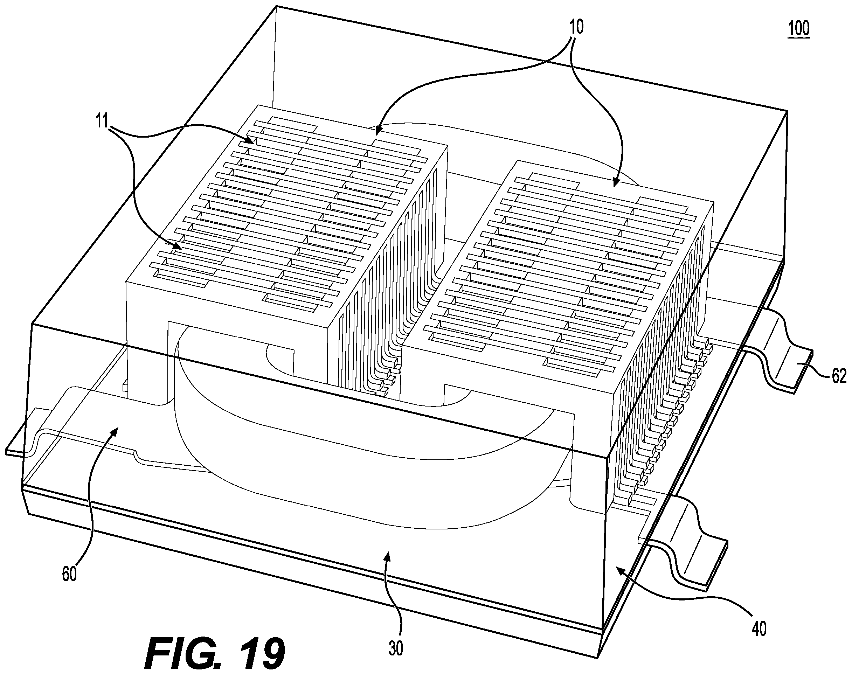

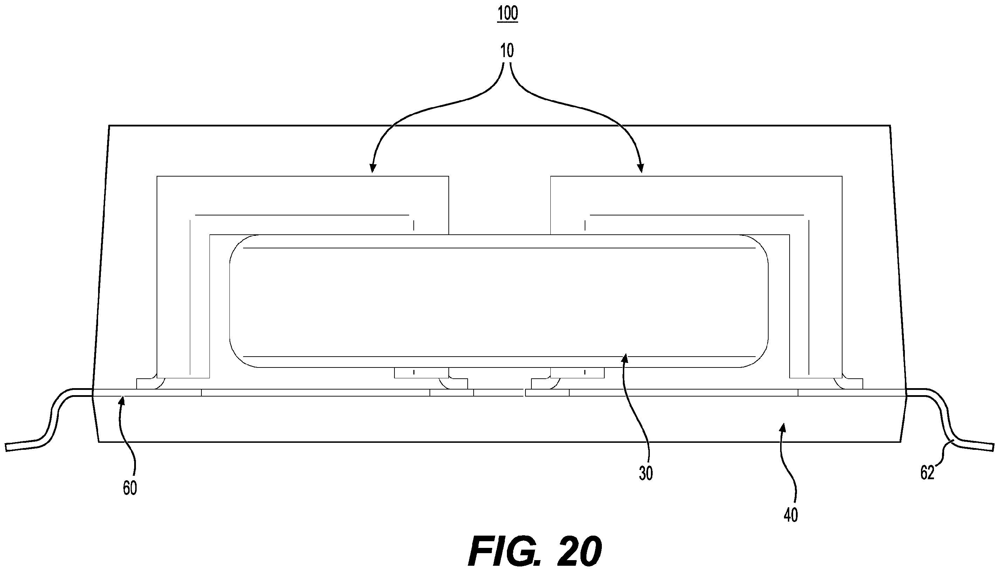

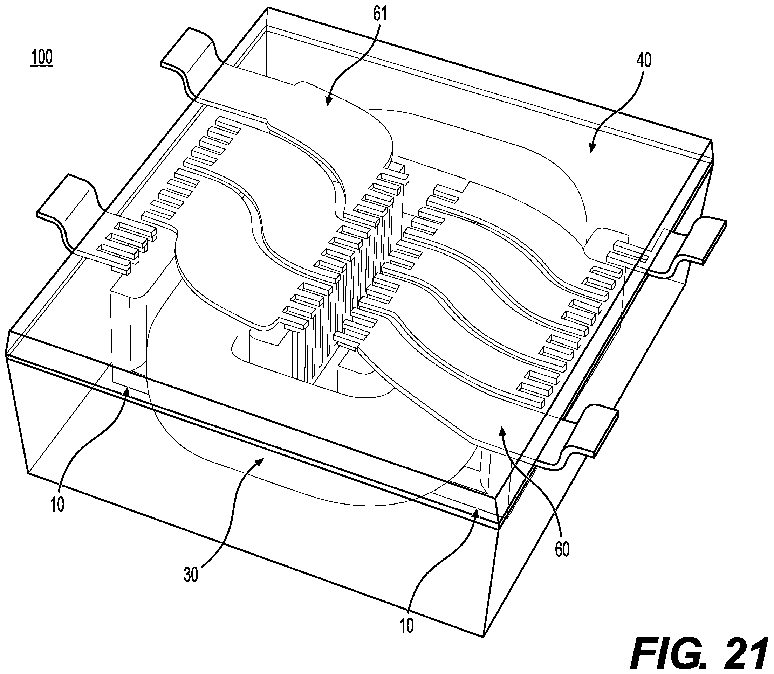

Figs. 19-23 show a magnetic component 100 similar to the magnetic component 100 of Fig. 1. For brevity, descriptions of similar components are not repeated. The magnetic component 100 can include the block coils 10 and the magnetic core 30 of the magnetic component 100 of Fig. 1.

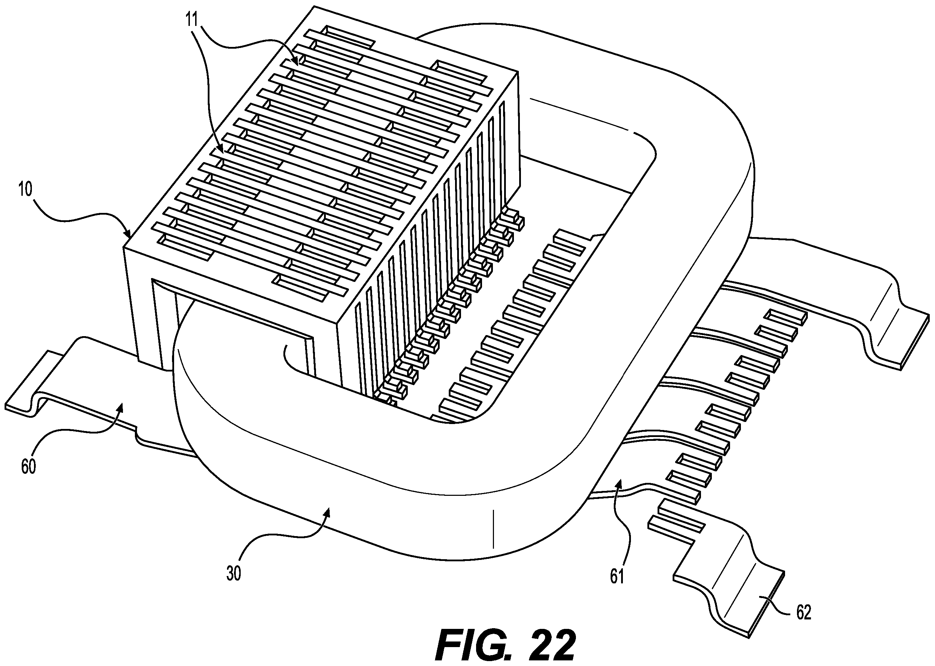

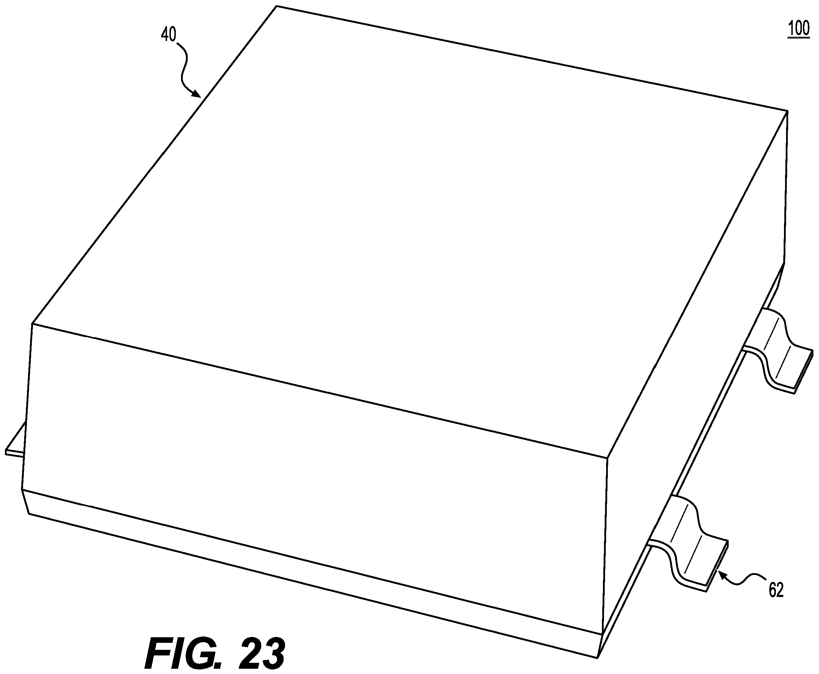

The magnetic component 100 of Figs. 19-23 is different from the magnetic component 100 of Fig. 1 in that the block coils 10 of the magnetic component 100 of Figs. 19-23 are connected to a lead frame 60 instead of a substrate 20. The magnetic component 100 of Figs. 19-23 includes an insulating material 40, which is similar to the insulating material 40 applied to the electronic module 200 of Fig. 4. In Figs. 19-21, the insulating material 40 is shown as transparent, but in Fig. 23, the insulating material 40 is shown as not being transparent. For clarity, Fig. 22 does not show the insulating material 40 and one of the block coils 10.

Although not shown, additional electronic components can be included to form an electronic module 200 so that the magnetic component 100 can be part of, for example, a DC-DC converter.

The lead frame 60 can include mounting terminals 62 and conductive patterns 61. The mounting terminals 62 can be used to connect the lead frame 60, and the magnetic component 100 or electronic module 200, to a host substrate (not shown). The conductive patterns 61 are similar to the traces 23 included on or in the substrate 20, and, as similarly described above, the conductive patterns 61 can connect one or more terminals 11 to define a single turn of winding. The conductive patterns 61 can determine which winding a terminal 11 is connected to. For example, the conductive patterns 61 can be connected to the terminals 11 such that one block coil 10 includes two turns of a primary winding and that the other block coil includes four turns of a secondary winding. The terminals 11 in the block coils 10 in the magnetic component 100 of Figs. 19-23 can be separated into different terminal groups as described above with respect to the block coils 10 in the magnetic component 100 of Fig. 1.

It should be understood that the foregoing description is only illustrative of the present invention. Various alternatives and modifications can be devised by those skilled in the art without departing from the present invention. Accordingly, the present invention is intended to embrace all such alternatives, modifications, and variances that fall within the scope of the appended claims.

## Claims

1. An electronic module comprising:
a substrate or a lead frame including a primary conductive pattern and a secondary conductive pattern;
a magnetic core located on or above the substrate or the lead frame;
a block coil including:
a resin body that is located on or above the substrate or the lead frame and that includes first, second, third, and fourth legs that extend over the magnetic core;
a first terminal that is on or embedded in the first and the second legs such that the first terminal extends over the magnetic core and that is connected to the primary conductive pattern; and
a second terminal that is on or embedded in the third and the fourth legs such that the second terminal extends over the magnetic core and that is connected to the secondary conductive pattern; and
an electronic component located on the substrate or the lead frame.

2. The electronic module according to claim 1, wherein
the block coil includes additional first terminals and additional second terminals;
the first terminal and the additional first terminals define a first terminal group; and
the second terminal and the additional second terminals define a second terminal group.

3. The electronic module according to Claim 2, wherein
each terminal in the first terminal group is connected to a corresponding primary conductive pattern; and
each terminal in the second terminal group is connected to a corresponding secondary conductive pattern.

4. The electronic module according to Claim 2 or 3, wherein the first terminal group is located next to and spaced away from the second terminal group.

5. The electronic module according to one of Claims 1-4, wherein the substrate or the lead frame includes first and second layers.

6. The electronic module according to Claim 5, wherein
the primary conductive pattern is in the first layer;
the secondary conductive pattern is in the second layer; and
from a side view of the substrate, a portion of the primary conductive pattern and a portion of the secondary conductive pattern overlap vertically.

7. The electronic module according to Claim 6, further comprising:
an additional primary conductive pattern in a third layer of the substrate; and
an additional secondary conductive pattern in a fourth layer of the substrate; wherein
from the side view of the substrate, a portion of the additional primary conductive pattern and a portion of the additional secondary conductive pattern overlap vertically.

8. The electronic module according to one of Claims 1-7, further comprising an insulating material covering the substrate or the lead frame, the magnetic core, and the block coil.

9. The electronic module according to one of Claims 1-8, wherein the electronic component includes an integrated circuit (IC) and/or a capacitor.

10. The electronic module according to one of Claims 1-9, wherein the block coil includes an inner tapered portion to which the magnetic core is connected.

11. An electronic module comprising:
a substrate or a lead frame including a conductive pattern;
a magnetic core located on or above the substrate or the lead frame;
first and second block coils connected by a bridge to define a single unitary component, each of the first and the second block coils including:
a resin body that is located on or above the substrate or the lead frame and that extends over the magnetic core; and
a first terminal that is on or embedded in the resin body and that is connected to the conductive pattern;
an electronic component located on the substrate or the lead frame; and
an insulating material covering the substrate or the lead frame, the magnetic core, and the block coil.

12. The electronic module according to Claim 11, wherein
the conductive pattern is a primary conductive pattern; and
the first terminal of the first block coil is connected only to the primary conductive pattern.

13. The electronic module according to Claim 11, wherein
the conductive pattern is a secondary conductive pattern; and
the first terminal of the second block coil is connected only to the secondary conductive pattern.

14. The electronic module according to one of Claims 11-13, wherein the resin body includes an inner tapered portion to which the magnetic core is connected.

15. The electronic module according to one of Claims 11-14, wherein
the first block coil includes a first terminal group and a second terminal group; and the first terminal of the first block coil is included in the first terminal group.

16. The electronic module according to Claim 15, wherein
each terminal in the first terminal group is connected to a corresponding primary conductive pattern; and
each terminal in the second terminal group is connected to a corresponding secondary conductive pattern.

17. The electronic module according to Claim 15, wherein each terminal in the first terminal group and each terminal in the second terminal group is connected to a corresponding primary conductive pattern.

18. The electronic module according to Claim 15, wherein each terminal in the first terminal group and each terminal in the second terminal group is connected to a corresponding secondary conductive pattern.

19. The electronic module according to one of Claims 15-18, wherein the first terminal group is located next to and spaced away from the second terminal group.

20. The electronic module according to one of Claims 11-19, wherein the substrate or the lead frame includes first and second layers.

21. The electronic module according to Claim 20, further comprising:
a primary conductive pattern in the first layer; and
a secondary conductive pattern in the second layer; wherein
from a side view of the substrate, a portion of the primary conductive pattern and a portion of the secondary conductive pattern overlap vertically.

22. The electronic module according to Claim 21, further comprising:
an additional primary conductive pattern in a third layer of the substrate; and
an additional secondary conductive pattern in a fourth layer of the substrate; wherein
from the side view of the substrate, a portion of the additional primary conductive pattern and a portion of the additional secondary conductive pattern overlap vertically.

23. The electronic module according to one of Claims 11-22, wherein the electronic component includes an integrated circuit (IC) and/or a capacitor.
